# EUROPÄISCHE PATENTSCHRIFT

(11) **EP 0 564 789 B1**
(45) Veröffentlichungstag und Bekanntmachung des Hinweises auf die Patenterteilung: **26.11.1997**
(21) Anmeldenummer: 93102336.0
(22) Anmeldetag: 15.02.1993
(51) Int. Cl.: H01J 37/32, C23C 14/32, C23C 14/54

(54) **Verfahren zur Werkstückbehandlung in einer Vakuumatmosphäre und Vakuumbhandlungsanlage**
Process for treatment of workpieces in a vacuum processing apparatus
Procédé pour traiter des pièces dans un dispositif de traitement sous vide

(30) Priorität: 24.03.1992 CH 948/92
(43) Veröffentlichungstag der Anmeldung: 13.10.1993
(73) Patentinhaber: BALZERS AKTIENGESELLSCHAFT, 9496 Balzers (LI)
(72) Erfinder: Signer, Hans, CH-9479 Oberschan (CH); Kügler, Eduard, A-6807 Feldkirch/Tisis (AT); Wellerdick, Klaus, CH-9470 Buchs (CH); Rudigier, Helmut, CH-7310 Bad Ragaz (CH); Haag, Walter, CH-9472 Grabs (CH)
(74) Vertreter: Troesch Scheidegger Werner AG

(56) Entgegenhaltungen:
- EP-A- 0 347 567
- WO-A-87/05053
- DE-C- 3 700 633

## Beschreibung

Die vorliegende Erfindung betrifft ein Verfahren nach den Oberbegriffen der Ansprüche 1 oder 2 sowie eine Anlage nach den Oberbegriffen der Ansprüche 27 oder 28.

Die Erfindung kann bei allen PVD-Verfahren (physical vapour deposition), reaktiven PVD-Verfahren sowie allen plasmaunterstützten CVD(chemical wafer deposition)-Verfahren eingesetzt werden sowie auch bei anderen Verfahren, sofern die genannten Verhältnisse vorliegen. Solche Verfahren sind insbesondere Sputtern, reaktiv oder nicht, bei welchen Werkstücke sputtergeätzt werden oder sputterbeschichtet werden und hierbei auf Bias gelegt sind, auf ein Bezugspotential oder potentialschwebend betrieben werden.

Im weiteren kann die Erfindung insbesondere im Rahmen von Ionenplattierverfahren, reaktiv oder nicht reaktiv, weiter auch bei Verdampfungsverfahren, d.h. Elektronenstrahl-Verdampfungsverfahren, Bogenverdampfungsverfahren, Verdampfungsverfahren mit Tiegelheizung, alle auch im Zusammenhang mit dem Ionenplattieren, eingesetzt werden, also - dies wiederholend - generell auf alle Vakuumbehandlungsverfahren, woran die erwähnte Ganz- oder Teilbelegung einer leitenden Fläche mit nicht oder schlecht leitendem Material auftritt, sei dies bedingt durch das spezifische Behandlungsverfahren oder sei dies dann, wenn derartige Belegungen bereits vor Verfahrensbeginn an eingesetzten leitenden Teilen vorliegen, wie bei Oberflächenoxidation von Metallteilen.

Immer, wenn die geschilderten Verhältnisse, nämlich Ganz- oder Teilbelegung und in der Vakuumatmosphäre Ladungsträger, erfüllt sind, also auch z.B. bei thermischen CVD-Verfahren, bei denen Ladungsträger z.B. zur Oberflächenaktivierung in Form von Ionen oder Elektronen eingebracht werden, als Elektronenstrahl oder auch als Ionenstrahl, ergeben sich Probleme dadurch, dass an der Belegung mit nicht oder schlecht leitendem Material, im weiteren "Isolationsbelegung" genannt, insbesondere wenn in der Vakuumatmosphäre elektromagnetische Kraftfelder angelegt sind und/oder durch inhomogene Ladungsverteilungen entstehen, eine weitere Belegung mit elektrischen Ladungsträgern einsetzt oder einsetzen kann, die im weiteren "Ladungsträgerbelegung" genannt wird. Dies führt zur elektrostatischen Aufladung der Isolationsbelegung, bis sich diese Aufladung unkontrolliert entlädt.

Grundsätzlich hat man bis anhin dieses Problem bei der elektrischen Speisung derartiger isolationsbelegter Flächen dadurch gelöst, dass entweder, als Betriebsquelle, ein AC-Signalgenerator angelegt wurde oder ein DC-Signalgenerator und ein AC-Signalgenerator. Trotz der, betrachtet über die Behandlungszeiten, nur relativ kurzzeitig negativ in Erscheinung tretenden stochastischen Störentladungen ging man mithin dazu über, während des gesamten Behandlungsprozesses permanent einen AC-Generator aufzuschalten, sei dies ein Impulsgenerator, ein RF-Generator etc.

Aus der US-PS-4 692 230 ist ein Verfahren bekannt, bei welchem, im Rahmen eines Kathodenzerstäubungsprozesses, ab Magnetronzielobjekten, sowohl elektrisch leitende wie auch isolierende Zielobjektmaterialien abwechselnd abgestäubt werden. Mit den abgestäubten Materialien wird ein Werkstück beschichtet. Bezeichnenderweise werden dann, wenn leitende Zielobjektmaterialien abgestäubt werden, diese in einer gleichstrombetriebenen Strecke abgestäubt. Dann, wenn die isolierenden Zielobjektmaterialien abgestäubt werden, erfolgt dies mit monopolaren Impulszügen eines AC-Generators. Diese Betriebsarten wechseln sich ab.

Die US-PS-4 693 805 beschreibt ein Verfahren zum Zerstäubungsbeschichten, ausgehend von dielektrischen Zielobjekten, oder für reaktives Zerstäubungsbeschichten, zum Zerstäubungsätzen etc., d.h. von Behandlungsprozessen, in welchen, in eingangs erwähntem Sinne, prozessinhärent, nicht oder schlecht leitende Materialien beteiligt sind und Isolationsbelegungen auftreten.

Um die elektrostatische Aufladung - Ladungsbelegungen - derartiger Isolationsbelegungen an einer ersten Strecke zwischen einer Zielobjektkathode und einer Anode zu beherrschen, wird eine zusätzliche Hilfsstrecke vorgesehen, zwischen dem erwähnten Zielobjekt und einer dritten Elektrode.

Die beiden Strecken, woran das Zielobjekt die gemeinsame Elektrode bildet, werden, ausgehend von je einem Gleichstromspeisegerät, über elektronisch gesteuerte Seriewiderstände, in Form von Transistoren, derart mit spezifischen Betriebskurvenformen sequentiell beaufschlagt, dass in den einen Zyklen die Potentiallegung des Zielobjektes zu dessen Zerstäubung führt und, in den dazwischenliegenden, die Ladungsbelegung vom erwähnten Zielobjekt, durch Feldaufbau an der Hilfsstrecke, abgebaut wird.

Während die letztgenannte US-PS die Oberflächenladungsbelegung über einen speziellen "Saugkreis" abführt, geht die DE-PS-31 42 900 den Weg, den Ionisierungsphasen sequentiell Neutralisationsphasen nachzuordnen, während welchen aufgebaute Ladungsbelegungen neutralisiert werden.

Für ein Ionenplattierverfahren wird nämlich in der DE-PS-31 42 900 eine Niederspannungs-Glimmentladungsstrecke zwischen einer Glühkathode und einer Anode vorgesehen. In Ionisierungsphasen wird die Glimmentladung gezündet, das von einem Verdampfungstiegel verdampfte, im wesentlichen neutrale Material ionisiert und auf das auf negatives Potential gelegte Werkstück hin beschleunigt. In den Neutralisationsphasen setzt die Plasma- und somit Ionenerzeugung aus, und es werden die aus der Glühkathode emittierten Elektronen zur Neutralisation der Ionenflächenbelegung an den Werkstückoberflächen ausgenützt. Durch entsprechende Beschaltung wird die Glimmentladungsstrecke mittels einer Kippschaltung betrieben.

Die EP-A-0 101 774 ihrerseits schlägt eine Technik vor, um bei einer Glimmentladung, die im "abnormalen" Mode betrieben wird, zu verhindern, dass sie in den Bogenentladungs-Mode umkippt. Bezüglich Definition dieser Modes sei z.B. auf die US-PS-3 625 848, Fig. 1, verwiesen. Hierzu wird an der Glimmentladungsstrecke eine Strommessung vorgenommen und zur Begrenzung des Stromes bei Entstehen eines Plasmabogens ein Widerstand zugeschaltet. Damit wird einer bereits entstandenen Bogenentladung zwischen den Glimmentladungselektroden entgegengewirkt.

Die EP-A-0 062 550 schlägt vor, bei einem reaktiven Behandlungsprozess die Glimmentladung impulszubetreiben. Um mit der Temperatur eines Behandlungsofens, unabhängig von der Plasmaentladung, die Werkstücktemperatur stellen zu können, wird ein "kaltes" Plasma dadurch erzeugt, dass zwischen den Impulsen die zugeführte elektrische Energie abgesenkt wird, so dass die Plasmaentladung gerade nicht löscht.

Aus der DE-PS-33 22 341 ist es weiter bekannt, die Probleme, dass bei einer mit möglichst hoher Spannung betriebenen Glimmentladung die Gefahr besteht, dass die Glimmentladung in eine Bogenentladung umkippt (s. zur EP-A-0 101 774), und dass bei mit Gleichstrom betriebener Entladung ein grundsätzlicher Nachteil darin bestehe, dass Druck und Temperatur gekoppelt sind, dadurch zu lösen, dass die Glimmentladung intermittierend jeweils mit einer Impulsspitze zum Zünden und anschliessend einem Signalbereich mit zum Aufrechterhalten der Glimmentladung geeigneten Pegel betrieben wird. Es sind Verfahren mit sonst bekanntlich gleichstrombetriebener Glimmentladung angesprochen.

Auch die US-PS-3 437 784 setzt sich zum Ziel, bei einer Glimmentladung das Uebergehen in den Bogenentladungsmode mit lokalem Bogen zwischen den Elektroden zu verhindern. Dies wird dadurch erreicht, dass der Glimmentladungsstrecke ein zweiweg-gleichgerichtetes, netzfrequentes Signal zugeführt wird, wobei die Amplitude der Halbwellen so gewählt ist, dass in den einen Halbwellenabschnitten die Glimmentladung gezündet wird, in den angrenzenden gelöscht wird, so, dass sich Ionen in einem in Ausbildung begriffenen Bogenentladungspfad rekombinieren können. Genügen die durch die Halbwellen zur Verfügung gestellten Rekombinationszeitspannen nicht, entsprechend den Halbwellenphasen unterhalb eines Zündspannungsniveaus, so wird mittels eines mechanisch betätigten Synchrongleichrichters, in Form eines Serieschalters, eine Speisungsabtrennung zwischen sich folgenden Zündphasen erstellt.

Die US-PS-4 863 549 beschreibt ein Hochfrequenzätzverfahren, bei welchem die Glimmentladung hochfrequenzbetrieben wird und der Zerstäubungsionenstrom auf das Werkstück durch ein Mittenfrequenzsignal (90 - 450kHz) gesteuert wird und dabei, um nicht die Amplitude letzterwähnten Signals ändern zu müssen, durch Pulspaket-Breitenmodulation.

Aus der EP-A-0 432 090 ist ein reaktives Ionenplattierverfahren bekannt, bei welchem eine Glimmentladungsstrecke zwischen Glühkathode und einem Tiegel mit zu verdampfendem Material unterhalten wird und das verdampfte Material ionisiert wird.

Ein Werkstückträger wird mit einer pulsierenden Gleichspannung bezüglich eines Referenzpotentials, sei dies Anoden- oder Kathodenpotential der Glimmentladung, betrieben. Mit dem pulsierenden Betrieb der Werkstückträgerstrecke werden speziell gute keramische Schichten auf den Werkstücken abgelegt.

Die pulsierende Gleichspannung wird als modulierbarer Rechteckimpulszug durch einen hierfür vorgesehenen Impulsgenerator erzeugt.

Aus der DE-PS-37 00 633 schliesslich ist es bekannt, eine Glimmentladung oder eine Bogenentladung durch Gleichstromimpulse - Rechteckimpulse - von einer Impulsspannungsquelle zu unterhalten. Dies, um Werkstücke thermisch schonend zu behandeln.

Aus der EP-A-0 432 488 ist ein Plasmaprozess bekannt, der permanent mit Hochfrequenz betrieben wird. Nach Abschalten der Hochfrequenzentladung werden Ladungsträger elektrostatisch vom Werkstück weg beschleunigt.

Aus der EP-0 347 567 ist es, zur Lösung des obgenannten Belegungsproblems, bekannt, während der Werkstückbehandlung sowohl das Ausgangssignal eines Gleichstrom-Signalgenerators wie auch dasjenige eines Hochfrequenz-Signalgenerators permanent an die Flächen aufzuschalten.

Die vorliegende Erfindung geht von der Einsicht aus, dass die Tatsache, dass die erwähnten Phänomene nur relativ kurzzeitig in den Behandlungsprozess beeinträchtigender Weise auftreten, das aufwendige Vorsehen eines AC-Generators dann nicht rechtfertigt, wenn Möglichkeiten bestehen, die erwähnten Phänomene, quasi zeitselektiv, dann und so lange signaltechnisch zu bekämpfen, wie das überhaupt nötig ist, um ein betrachtetes Behandlungsverfahren mit beabsichtigtem Resultat durchzuführen.

Diese Aufgabe wird bei elektrischer Speisung der genannten Flächen in grundsätzlicher Art durch das Vorgehen nach dem kennzeichnenden Teil von Anspruch 1 gelöst.

Damit können zusätzlich zum Gleichstrom-Signalgenerator andere Signalerzeuger für das weitere Signal gezielt nur so lange wie nötig aktiviert werden und entsprechend auch dimensioniert werden, wie dies, z.B. aus Vorexperimenten ermittelt, die Ladungsbelegungsverhältnisse erfordern. Andernfalls können die Ladungsbelegungsverhältnisse in "real time" erfasst und entsprechend der Einsatz des zusätzlichen Signals bemessen werden.

Es wird erreicht, dass eine "gefährliche" Ladungsbelegung trotz elektrischer Gleichstrom-Generatorspeisung nicht entsteht.

Im weiteren soll durch die vorliegende Erfindung die elektrostatische Wirkung einer vorhandenen, insbesondere auch - wie beim Ionenplattieren - einer prozessinhärent gewollten Ladungsbelegung behoben werden und dabei die Belegung weitestgehend beibehalten werden. Dies unabhängig davon, ob die betrachteten Flächen extern elektrisch wie auch immer gespiesen werden. Dies wird bei Vorgehen nach dem Kennzeichen von Anspruch 2 erreicht.

Ein ganz typisches Beispiel, bei welchem, prozessinhärent, eine Ladungsbelegung gewollt ist, ist das erwähnte Ionenplattieren, bei welchem Ionen aus der Vakuumatmosphäre an eine Werkstückoberfläche abgelegt werden sollen, um eine erwünschte Schicht aufzubauen. Dabei werden die Belegungsionen durch elektrische Felder in der Vakuumatmosphäre an die zu belegende Oberfläche getrieben. Aufgrund dieses beim Ionenplattieren inhärenten Vorganges war es bis anhin gar nicht möglich, Schichten aus nicht oder schlecht leitendem Material durch Ionenplattieren aufzubringen oder auf nicht oder schlecht leitende Oberflächen von Werkstücken, durch Ionenplattieren, Schichten auch aus leitenden Materialien abzutragen. Dies deshalb, weil ein Durchgriff durch sich aufbauende Belegungen aus nicht oder schlecht leitendem Material zur Erzeugung des Feldes in der Vakuumatmosphäre rasch nicht mehr möglich war oder bei bereits vorhandener, nicht oder schlecht leitender Werkstückoberfläche ab Beginn nicht möglich war.

Das Ionenplattieren ist mithin ein Verfahren, bei dem
a) durch ein extern aufgebrachtes monodirektionales elektrisches Feld in der Vakuumatmosphäre Ionen an ein Werkstück abgelegt werden sollen und damit eine externe elektrische Potentiallegung des Werkstückes notwendig ist,
b) die Belegung mit Ionen nicht abgebaut werden darf, weil sonst das Prozessziel nicht erreicht ist, die effiziente Schichtbildung.

Durch Kombination beider erfindungsgemässen Lösungsaspekte gemäss Anspruch 3 werden somit gewisse Verfahren, wie insbesondere das erwähnte Ionenplattierverfahren, unter den erwähnten Isolationsbelegungsbedingungen überhaupt erst möglich.

Wie erwähnt, können die Isolationsbelegungen behandlungsfremd gebildete Belegungen sein, z.B. durch unkontrolliertes Reagieren von in der Behandlungsatmosphäre verbleibenden Verschmutzungsgasen, deren Reaktionsprodukte sich an Oberflächen, die der Behandlungsatmosphäre ausgesetzt sind, ablegen, oder durch Verunreinigungsschichten auf leitenden Gegenständen vorab gebildet sein, wie durch Oxidschichten auf Metallen. Sie können aber auch prozessinhärent gebildet werden, wie bei Beschichtungsprozessen nicht oder schlecht leitender Materialien und/oder bei der Beschichtung mit Schichten nicht oder schlecht leitenden Materials, wobei dann die Ladungsbelegung die Isolationsbelegung aufbaut.

Bei Behandlungsprozessen, bei denen, prozessbedingt, keine schlecht oder nicht leitenden Materialien beteiligt sind, ist es verbreitet, Strecken zwischen zwei metallischen Flächen in der Vakuumatmosphäre mit Gleichstromsignalen zu betreiben, sei dies z.B. zum Unterhalt einer Plasmaentladung oder zur Bias-Legung von Werkstücken, Schirmen, Elektroden etc.

Obwohl bei diesen Prozessen, wie erwähnt, keine schlecht oder nicht leitenden Materialien beteiligt sind, ist es ebenso bekannt, dass sich beispielsweise an metallischen Körpern an Normalatmosphäre eine Verunreinigungsschicht aufbaut, wie insbesondere eine Oxidschicht. Wenn solche Flächen dann prozessbeteiligt werden, ergeben sich in den Anfangsphasen derartiger Prozesse bekanntermassen die besprochenen stochastischen Entladephänomene, welche aber deshalb in Kauf genommen werden, weil das Vorsehen von AC-Generatoren nur gerade zur Behebung dieser Phänomene in der Anfangsphase eines Behandlungsprozesses, vom Aufwand her betrachtet, nicht zu rechtfertigen wäre. Es werden aber angeschaltete Quellen und Generatoren und andere Anlageaggregate durch diese anfänglichen Erscheinungen massiv elektrisch und/oder mechanisch/ thermisch belastet und müssen entsprechend abgesichert bzw. dimensioniert bzw. häufig ersetzt werden.

Gerade auch dieses Problem wird durch die Erfindung unter dem eingangs erwähnten ersten Aspekt durch vorgehen nach Anspruch 1 gelöst, ohne dass aufwendige AC-Generatoren notwendig wären.

Mit der Erfindung wird, zusammengefasst, einerseits das Ladungsbelegungsproblem gelöst, wenn Gleichstromgeneratoren eingesetzt werden, wo bis anhin, kombiniert, DC- und AC-Generatoren eingesetzt wurden, jeweils mit für Dauerbetrieb erforderlicher Auslegung, anderseits das Ladungsbelegungsproblem gelöst, wenn Ladungsträgerbelegungen an Isolationsbelegungen oder wenn Ladungsträgerbelegungen selbst eine Isolationsbelegung aufbauen, wobei die der Ladungsbelegung entsprechende Materiebelegung nicht wesentlich gestört werden soll, nämlich durch elektrische Neutralisierung.

Beim Einsatz des erfindungsgemässen Vorgehens, insbesondere aufgrund des Beherrschbarwerdens von Ladungsbelegungen, ergeben sich grundsätzlich neuartige Behandlungsverfahren. Die Erfindung beschränkt sich bereits unter ihrem ersten Aspekt nicht nur darauf, vorbekannte elektrische Speisungen durch vereinfachte zu ersetzen. Dies, obwohl sich bestehende Anlagen mit Gleichstromspeisung ohne weiteres durch Vorsehen eines die Erfindung realisierenden Zusatzmoduls, ohne grossen technischen Aufwand, für Verfahren umbauen lassen, die sich nur höchst störanfällig - Startstörungen durch Oxidbelegungen von Metalloberflächen - oder überhaupt nicht, mit Gleichstromgeneratorspeisung, durchführen liessen.

Dadurch, dass nun gemäss Wortlaut von Anspruch 4 vorgegangen wird, ergibt sich eine höchst einfache Art, das Gleichstromsignal des Generators zu ändern, wobei sich Repetitionsfrequenz und Tastverhältnis einfach optimal einstellen lassen.

Durch selektive Wahl von Repetitionsfrequenz und Tastverhältnis des Zerhackens, welches vorzugsweise nach dem Wortlaut von Anspruch 5 ausgebildet ist, lässt sich der Wirkungsgrad dadurch einfach optimieren, dass nur gerade während notwendigen Zeitabschnitten und notwendig oft die Gleichstromsignaleinspeisung zerhackt wird, um mit Einkopplung eines Signals mit breitem Frequenzspektrum, wie es beim Zerhacken des Gleichstromgeneratorausgangssignals entsteht, während optimal kurzen Phasen, in welchen die zugeführte Leistung verringert wird, das Auftreten von Störentladungserscheinungen zu verhindern. Im weiteren ergibt sich bei Vorgehen nach Anspruch 5 eine optimale Kombination der Erfindung unter ihren beiden Aspekten "Gleichstromsignalgeneratorspeisung" und "Streckenentladung".

Das Verfahren kann an mindestens einem Werkstück vorgenommen werden, welches eine Oberfläche aus nicht oder schlecht leitendem Material aufweist, welche behandelt wird, z.B. mit einer leitenden oder nicht bzw. schlecht leitenden Schicht belegt wird und/oder dessen wie auch immer geartete Oberfläche, ob leitend oder nicht leitend, mit einer Schicht aus schlecht oder nicht leitendem Material beschichtet wird. Dabei wird dann das Werkstück auf einer der leitenden Flächen abgelegt.

Insbesondere wird es möglich, an einem Werkstück mit nicht oder schlecht leitender Oberfläche eine Schicht aus leitendem Material abzulegen.

Ein ausserordentlich wichtiger Fall als Teil des erfindungsgemässen Verfahrens ist nach dem Wortlaut von Anspruch 6 das Ionenplattieren, womit auf Oberflächen aus leitendem, nicht oder schlecht leitendem Material Schichten aus nicht oder schlecht leitendem Material abgelegt werden oder auf Oberflächen aus nicht oder schlecht leitendem Material eine leitende Schicht.

Wie eingangs erwähnt wurde, eignet sich das erfindungsgemässe Vorgehen unter all seinen Aspekten generell für PVD-Behandlungsverfahren, darunter auch reaktive PVD-Verfahren, oder für plasmaunterstützte CVD-Verfahren insbesondere, weil diesen Verfahren allen gemein ist, dass in der Behandlungsatmosphäre Ladungsträger vorhanden sind. Selbstverständlich kann aber das erfindungsgemässe Vorgehen auch bei anderen Verfahren eingesetzt werden, wie beispielsweise thermischen CVD-Verfahren, wenn in der Behandlungsatmosphäre Ladungsträger vorhanden sind.

Dem Wortlaut von Anspruch 7 folgend, umfassen die erfindungsgemässen Verfahren die Erzeugung eines Plasmas, sei dies eine Glimmentladung der verschiedenen bekannten Arten oder auch eine Bogenentladung oder ein in bekannter Art und Weise durch Magnetfeld- oder Mikrowelleneinkopplung erzeugtes Plasma.

Wird das Plasma durch eine Entladung zwischen Elektroden erzeugt, so wird vorzugsweise nach dem Wortlaut von Anspruch 8 vorgegangen.

Es hat sich, aus Stabilitätsgründen, als vorteilhaft erwiesen, eine der Elektroden, ab welcher das Plasma gespiesen wird, auf das Potential einer der genannten Flächen zu legen, auch dann, wenn keine der erwähnten plasmabildenden Elektroden als eine der erfindungsgemäss betriebenen Flächen eingesetzt wird.

Im weiteren wird bevorzugterweise dem Wortlaut von Anspruch 9 folgend vorgegangen.

Um die Signifikanz einer solchen Messung zu erkennen, sei bereits jetzt, ohne Anspruch auf physikalische Exaktheit, der Mechanismus erläutert, welcher beim erfindungsgemässen Verbinden nach dem Wortlaut von Anspruch 2, an der angesprochenen Strecke zwischen den zwei leitenden Flächen, ablaufen dürfte.

Eine schlecht oder nicht leitende Materialphase, die Isolationsbelegung einer der erwähnten leitenden Flächen, deren Oberfläche der Vakuumatmosphäre mit den Ladungsträgern ausgesetzt ist, wirkt als Kondensator. Der eine Abgriff wird durch die leitende Fläche gebildet, welche auch die eine Kondensatorplatte bildet. Die zweite "Kondensatorplatte" wird durch das "Interface" zu der mit Ladungsträgern versehenen Atmosphäre gebildet. Die Atmosphärenstrecke zwischen der isolierenden Oberfläche und der zweiten leitenden Fläche bildet eine, dank der vorhandenen Ladungsträger, leitende Verbindung. Eine Ladungsbelegung der erwähnten nicht oder schlecht leitenden Oberflächen bzw. entsprechender Oberflächenbereiche oder -inseln entspricht der Aufladung des genannten Kondensators.

Von diesem Modell ausgehend, ist es dieser Kondensator, der erfindungsgemäss über den Entlade- bzw. Umladestromzweig gezielt entladen bzw. umgeladen wird. Anstatt den die Ladungsbelegung bildenden Ionen, durch entsprechende Signalgestaltung eines gegebenenfalls aufgeschalteten elektrischen Speisesignals, genügend Zeit für eine Rekombination zu geben, wird erfindungsgemäss der durch die erwähnte Ladungsbelegung aufgeladene Kondensator in höchst einfacher Art und Weise und äusserst rasch durch mindestens kurzzeitiges Kurzschliessen entladen oder gegebenenfalls umgeladen. Dadurch wird die Ladungsbelegung an der nicht oder schlecht leitenden Oberfläche, üblicherweise durch positive Ionen gebildet, im Rahmen der hohen Beweglichkeit der Elektronen in der Vakuumatmosphäre sehr rasch neutralisiert. Es bildet sich an der genannten Oberfläche eine, gesamthaft elektrisch neutrale, Ladungsdoppelschicht. Aufgrund dieses Mechanismus ist der Ausdruck "entladen" eher als "neutralisieren" zu verstehen.

Da sich die mit den Ladungen belegten Oberflächen der Isolationsbelegung mit der dazu seriegeschalteten Impedanz der Atmosphärenstrecke zu der weiteren leitenden Fläche, in erster Näherung, wie die Serieschaltung diskreter Widerstands- und Kapazitätselemente verhält, was erfindungsgemäss ja ausgenützt wird, ist nun ersichtlich, dass der in Entlade- bzw. Umladezeitphasen im genannten Entladekreis fliessende Strom, wie er, dem Wortlaut von Anspruch 9 folgend, gemessen wird, signifikant ist für die Ladungsbelegung sowie, bei im wesentlichen konstantem Ersatzwiderstand der erwähnten Strecke, für den Kapazitätswert des erwähnten Kondensators und mithin für die Dicke der Isolationsbelegung.

Die erfindungsgemäss durch den Entladungskurzschluss erreichte Neutralisation wird in derart kurzen Zeiten erreicht, dass, bei der erfindungsgemässen Kombination mit Gleichstromgeneratorspeisung, die Entladevorgänge nur minimal den Wirkungsgrad des eigentlichen gleichstromsignalgespiesenen Verfahrens beeinträchtigen und trotzdem diese Speisungsart ermöglichen.

Wesentlich ist weiter, dass gerade bei Prozessen, bei denen die Ionenbelegung - mit Materialbelegung einhergehend - Prozessziel ist, wie beim Ionenplattieren, bei der erfindungsgemässen Neutralisierung der Ladungsbelegung im wesentlichen kein Materialabtransport, weg von der belegten Oberfläche, einsetzt, sondern die Ladungsneutralisierung mittels zusätzlich angelagerter, gegenpoliger Ladungsträger erfolgt. Die erwähnte Ladungsbelegung wird elektrisch neutralisiert, was für die Prozessführung und das Resultat des Prozesses von grosser Wichtigkeit ist.

Aus dem gemessenen Entlade- bzw. Umladeverhalten kann auf die Dicke einer nicht oder schlecht leitenden Schicht an einer der genannten Flächen geschlossen werden. Es kann aus der Zeitkonstanten der jeweiligen Entladeverhalten, die bekanntlich nicht, und im vorliegenden Fall - Ionenleitung - genähert nicht, vom Betrag der Ladungsbelegung abhängt, auf den jeweils vorherrschenden Kapazitätswert und damit mindestens auf die von Entladezyklus zu Entladezyklus zunehmende Schichtdicke geschlossen werden: Mit zunehmender Schichtdicke nimmt die Entladezeitkonstante ab. Aus Beobachtung dieser Zeitkonstanten kann mithin auf das Schichtwachstum geschlossen werden.

Anderseits kann aus dem gemessenen Entlade- bzw. Umladeverhalten auch auf die Belegung mit Ladungsträgern geschlossen werden, denn der Pegel des Entladeverhaltens (Anfangswert) ist wohl vom Widerstandswert der Atmosphärenstrecke, nicht vom Kapazitätswert des Kondensators, vor allem aber vom Ladezustand des erwähnten Kondensators und damit der Ladungsbelegung abhängig.

Gerade bei Verfahren, bei welchen es Prozessziel ist, nachmals zu neutralisierende Ladungsträger auf einer Werkstückoberfläche abzulegen, kann es ausserordentlich vorteilhaft sein, den Aufbau der Ladungsbelegung auf der Isolationsbelegung zu messen. Dies ist beispielsweise dadurch möglich, dass die betrachtete leitende Fläche über einen Ladungsverstärker auf ein Bezugspotential gelegt wird und die in diesem Messzweig fliessende Ladung, Funktion der sich aufbauenden Ladungsbelegung, gemessen wird.

Nach einer weiteren Ausführungsvariante gemäss Wortlaut von Anspruch 10 wird das gemessene Entlade- bzw. Umladeverhalten als IST-Verhalten mit einem SOLL-Verhalten verglichen, und in Funktion des Vergleichsresultates wird die Ladungsbelegung durch externe Ladungseinspeisung und/oder Aenderung der Entlade- bzw. Umladezyklushäufigkeit und/oder Aenderung der Entlade- bzw. Umladezykluslänge so geändert, dass das resultierende, gemessene IST-Entlade- bzw. -Umladeverhalten dem SOLL-Verhalten mindestens angenähert wird.

Eine weitere Eingriffsmöglichkeit ergibt sich, vor allem für Plasmazerstäubung, durch das bevorzugte Vorgehen nach Anspruch 11.

Im weiteren wird bevorzugterweise vorgeschlagen, dem Wortlaut von Anspruch 12 zu folgen. Damit wird erreicht, dass, praktisch adaptiv an das jeweilige Entladeverhalten, die Entladezykluszeitspannen optimal kurz gehalten werden und dies mit signaltechnisch einfachen Mitteln.

Im weiteren wird vorgeschlagen, nach dem Wortlaut von Anspruch 13 vorzugehen. Dadurch wird es möglich, bei Verfahren, bei welchen es im obgenannten Sinne Verfahrensziel ist, eine Belegung zu erwirken, jedoch dies, prozessbedingt, nur mit einer Ladungsbelegung einhergeht, zu erreichen, dass die Rate des Belegungsaufbaues gesteuert bzw. geregelt werden kann, wobei diese erst als Ladungsbelegung auftretende Belegung in nachfolgenden Entlade- bzw. Umladezyklen elektrisch neutralisiert wird und als neutralisierte Belegung bzw. Schicht auf der Zielfläche verbleibt, sei dies als eine leitende oder eine weitere, nicht oder schlecht leitende Schicht auf einer Isolationsbelegung oder sei dies auf einer leitenden Oberfläche als eine nachmals als Isolationsbelegung wirkende Schicht.

Dem Wortlaut von Anspruch 14 folgend, wird in einem bevorzugten Ausführungsbeispiel der Ladungsbelegungsaufbau als Schichtaufbau auf mindestens ein Werkstück beim Ionenplattieren gesteuert.

Wenn zwischen Elektroden eine Plasmaentladung unterhalten wird, so muss über diese Elektroden die für den Unterhalt der Entladung notwendige Energie eingespiesen werden, wenn nicht zusätzliche Energie, beispielsweise induktiv, in den Entladungsraum eingekoppelt wird. Es herrscht mithin zwischen derartigen Elektroden nicht nur eine Potentialdifferenz, sondern es fliesst auch ein wesentlicher Strom, nämlich der Plasmaentladungsstrom.

Dies ist bei Strecken nicht der Fall, bei denen mindestens eine der Elektroden an der Aufrechterhaltung der Plasmaentladung nicht unmittelbar beteiligt ist, also bei Strecken, mittels welchen beispielsweise ein Werkstück im Behandlungsraum im Sinne eines Bias-Betriebes auf Potential gehalten wird, wie beispielsweise bei der Potentiallegung von Werkstücken beim Ionenplattieren, derart, dass im Entladungsraum, für die positiven Ionen, ein Beschleunigungsfeld auf die Werkstückoberflächen hin wirkt.

Die Speisung derartiger Strecken ist relativ leistungsarm. Wie bereits erwähnt, handelt es sich bei den dabei bewegten Ionen bzw. Komplexionen um relativ grosse Teilchen relativ geringer Beweglichkeit.

Dieser grundsätzliche Unterschied lässt sich nun gezielt ausnützen. Dies wird bei bevorzugtem Vorgehen nach dem Wortlaut von Anspruch 15 erreicht.

Dadurch, dass in Serie mit dem erfindungsgemäss ausgenützten Kondensator - gebildet durch die Isolationsbelegung, die nicht oder schlecht leitende Werkstückoberfläche selbst, die bereits durch Beschichtung erstellt sein kann, oder eine während des Verfahrens erstellte Isolationsbelegung, nämlich eine abgelegte Schicht nicht oder schlecht leitenden Materials -, in Plattierungsphasen, eine diskrete Kapazität geschaltet wird und diese Serieschaltung in der erwähnten Plattierungsphase durch extern eingespiesene Ladung so aufgeladen wird, dass vorerst an der Plasmaentladungsstrecke zwischen der Werkstückträgerelektrode und der betrachteten, weiteren metallischen Fläche ein so gerichtetes elektrisches Feld entsteht, dass positive Ionen auf die Werkstückoberfläche hin beschleunigt werden, womit sich an letzterer schliesslich, wegen der Serieschaltung, eine gleichgerichtete Spannung aufbaut wie an der diskreten Kapazität, wird, durch Bemessung der erwähnten, extern zugeführten Ladung, die Rate abgelegter schichtbildender Ionen an den Werkstücken gesteuert.

Das Aufprägen einer gegebenen Ladung mit gegebenem Verlauf an die Serieschaltung zweier kapazitiver Elemente, die diskrete Kapazität und der erfindungsgemäss genutzte Kondensator, ist, wie dem Fachmann durchaus geläufig, aufgrund des differenzierenden Verhaltens einer Kapazität, durch Anlegen einer Spannung mit gegebener zeitlicher Ableitung ohne weiteres möglich.

Wenn danach, in den Entladungsphasen, Kapazität und Kondensator parallelgeschaltet werden, so wird durch den Entladevorgang der diskreten Kapazität derjenige des erfindungsgemäss ausgenützten Kondensators, gebildet durch die Isolationsbelegung am Werkstück, unterstützt. Wird insbesondere die diskret vorgeschaltete Kapazität wesentlich grösser gewählt als die des Belegungskondensators, so wird letzterer im wesentlichen auf die Spannung an der diskreten Kapazität umgeladen. Durch Bemessung des Kapazitätsverhältnisses der diskreten Kapazität und des erfindungsgemäss ausgenützten Kondensators kann das Entlade- bzw. Umlademass, insbesondere am letzterwähnten Kondensator, bestimmt werden.

Die Aufladung, insbesondere des erwähnten Kondensators, erfolgt mithin bevorzugterweise nach dem Wortlaut von Anspruch 16. Dies wiederum in bevorzugter Art und Weise nach dem Wortlaut von Anspruch 17, indem, wie erwähnt, eine Spannung mit vorgegebenem oder vorgebbarem Verlauf ihrer Aenderung in der Zeit aufgeschaltet wird.

Eine solche kann beispielsweise gemäss Wortlaut von Anspruch 18 mittels induktiver Spannungsüberhöhung im Seriekreis erfolgen oder bevorzugterweise dadurch, dass gemäss Wortlaut von Anspruch 19 die Aufladung des Seriekreises in Plattierungsphasen mittels einer Rampenspannung erfolgt, im wesentlichen mit einem konstanten Strom, und damit eine im wesentlichen konstante Ladungsbelegungsrate erzeugt wird. Selbstverständlich braucht dabei die angesprochene Rampe und der angesprochene, im wesentlichen konstante Strom nicht zwingend eine lineare Rampe bzw. ein absolut konstanter Strom zu sein, sondern durch Auslegung der Spannungskurvenform kann je nach Erfordernis der Zeitverlauf des Stromes gesteuert werden und damit die Belegungsrate pro Zeiteinheit.

Bei einer weiteren Ausführungsvariante nach dem Wortlaut von Anspruch 21 werden zwei oder mehr Paare der erwähnten Flächen vorgesehen, und es werden je solche Paare oder je Gruppen solcher Paare mit einem Gleichstromgenerator und/oder mit einem Entlade- bzw. Umladestromkreis betrieben und dies zeitgestaffelt. Würden mehrere der erwähnten Paare zeitsynchron gemäss vorliegender Erfindung betrieben, d.h. entweder zeitsynchron an den Ausgangssignalen der Gleichstromgeneratoren weitere Signale aufgeschaltet und/oder zu viele der erwähnten Paare zeitsynchron entladen bzw. umgeladen, so ergäbe sich unter Umständen eine unzulässige Beeinträchtigung der Behandlungsverhältnisse in der Vakuumkammer.

So ist ohne weiteres ersichtlich, dass beispielsweise durch die Entlade- bzw. Umladevorgänge dem Behandlungsraum elektrische Energie entzogen wird. Wäre dies bei zu vielen gleichzeitigen Entladevorgängen zu hoch, so könnten sich, beispielsweise an einer Plasmaentladung, Unstabilitäten einstellen.

Deshalb wird vorgeschlagen, in diesen Fällen zeitgestaffelt erfindungsgemäss vorzugehen. Insbesondere wird, gemäss Wortlaut von Anspruch 22, beim Ionenplattieren auf diese Art und Weise vorgegangen.

Durch das zeitgestaffelte Entladen der erfindungsgemäss betriebenen, mindestens zwei Paare oder der Gruppen der beschriebenen Flächen, wird dem Plasmaentladungsprozess nicht zu gleichen Zeiten Energie entzogen.

Spezifisch beim Ionenplattieren ist es vorteilhaft den Entladevorgang zu messen, mit einem SOLL-Vorgang zu vergleichen und durch Variation der Aufladung des Seriekreises in Plattierungsphasen, in Funktion des Vergleichsresultates, die Ladungsbelegung durch Ionen am Werkstück und mithin, gegebenenfalls unter Berücksichtigung aus Zeitkonstantenänderungen am Entladevorgang ermittelter Aenderungen des Kondensators, den gemessenen Entladevorgang dem SOLL-Vorgang mindestens anzugleichen.

insbesondere beim erfindungsgemässen Einsatz eines Ionenplattierverfahrens wird vorgeschlagen, dem Wortlaut von Anspruch 20 folgend, den Entladevorgang mit einer Repetitionsfrequenz von 50kHz bis 500kHz vorzunehmen, bevorzugterweise mit mindestens 90kHz und besonders bevorzugterweise mit mindestens 100kHz.

Duch das Ionenplattieren kann mindestens eine korrosionsfeste und/oder mindestens eine verschleissfeste Schicht erzeugt werden, z.B. eine nicht oder schlecht leitende erste Schicht als Korrosionsschutzschicht und eine leitende zweite Schicht als Verschleissschutzschicht oder weitere Kombinationen von Schichten auch als Schichtsystem mit zwei und mehr Schichten auf mindestens einem Werkstück abgelegt.

Eine weitere bevorzugte, Ausführungsform des erfindungsgemässen Verfahrens zeichnet sich nach dem Wortlaut von Anspruch 23 aus.

Dadurch werden Probleme einer verfahrensunabhängigen, vor Belegung des leitenden, zu zerstäubenden Materials, sowie einer nachmals während des Prozesses einsetzenden Isolationsbelegung mit der durch den reaktiven Zerstäubungsprozess gebildeten Verbindung, im Sinne der genannten stochastischen bzw. spontanen Entladeerscheinungen, nicht auftreten, womit ab Beginn des Verfahrens der Prozess stabil geführt werden kann, trotz Einsatzes eines Gleichstromsignalgenerators als Hauptenergiequelle.

Insbesondere wenn der Gleichstromsignalgenerator Stromquellencharakteristik aufweist wird die Unterbrechungsschaltstrecke mittels eines Netzwerkes, vorzugsweise eines passiven, dabei weiter bevorzugterweise eines Widerstandsnetzwerkes, überbrückt. Dadurch wird erreicht, dass während Unterbrechungsphasen zwischen Generatorausgang und Plasmaentladungsstrecke, während welchen mindestens kurzzeitig der Entladestromkreis durchgeschaltet wird, über der Unterbrechungsschaltstrecke eine nur begrenzte Spannung anliegt, die damit zu schalten ist.

Gemäss Wortlaut von Anspruch 24 wird der erfindungsgemässe reaktive Kathodenzerstäubungsprozess im oxidischen oder im Uebergangsmode betrieben. Dabei kann Silicium kathodenzerstäubt und mit Sauerstoff zur Bildung eines Siliciumoxides SiₓO_{y}, insbesondere von SiO₂, zur Reaktion gebracht werden.

Generell können mit dem erfindungsgemässen reaktiven Kathodenzerstäubungsprozess dielektrische bzw. schlecht oder halbleitende Schichten auf Metallbasis erzeugt werden.

Dem Wortlaut von Anspruch 25 folgend, wird bei dem erfindungsgemässen Verfahren mit Kathodenzerstäubungsprozess das weitere Signal mit einer Häufigkeit entsprechend 50Hz bis 1MHz, vorzugsweise entsprechend 5kHz bis 100kHz, vorzugsweise dabei insbesondere von 10kHz bis 20kHz angelegt.

Im weiteren wird bevorzugterweise, dem Wortlaut von Anspruch 26 folgend, das weitere Signal jeweils mit Längen von 50nsec bis 10µsec, vorzugsweise von 0,5µsec bis 2µsec oder von 2µsec bis 10µsec angelegt. Dies selbstverständlich in Abstimmung mit den jeweils bevorzugterweise eingesetzten Repetitionsfrequenzen.

Die der vorliegenden Erfindung zugrundeliegenden Aufgaben werden durch Vakuumbehandlungsanlagen nach dem Wortlaut der Ansprüche 27 bzw. 28 gelöst, in bevorzugter Kombination nach dem Wortlaut von Anspruch 29.

Weitere bevorzugte Ausführungsvarianten der erfindungsgemässen Anlagen mit den im Zusammenhang mit den bevorzugten Ausführungsvarianten der Verfahren erläuterten Vorteilen sind in den Ansprüchen 30 bis 50 spezifiziert.

Die Erfindung wird anschliessend beispielsweise anhand von Figuren erläutert.

Es zeigen:
- Fig. 1a und 1b: schematisch anhand eines Funktionsblockdiagrammes je bekannte Vorgehensweisen bei der elektrischen Speisung isolationsbelegter, elektrisch leitender Flächen in Vakuumbehandlungskammern,
- Fig. 2: anhand eines Funktionsblockdiagrammes, das prinzipielle erfindungsgemässe Vorgehen bei der genannten elektrischen Speisung unter dem ersten Aspekt der vorliegenden Erfindung,
- Fig. 3: in analoger Darstellung zu derjenigen von Fig. 2 die vorliegende Erfindung unter ihrem zweiten Aspekt,
- Fig. 4: in Darstellung analog zu den Fig. 1 bis 3 das Vorgehen gemäss vorliegender Erfindung bei bevorzugter Kombination ihrer Aspekte, wie sie in Fig. 2 bzw. 3 je einzeln prinzipiell dargestellt sind,
- Fig. 5a bis 5c: schematisch und ohne jeglichen Anspruch auf wissenschaftliche Exaktheit die Darstellung einer Strecke in einem Vakuumbehandlungsraum mit nicht oder schlecht leitender Materialbelegung, einer Isolationsbelegung, um die Ladungsbelegungserscheinungen und deren erfindungsgemässe Neutralisierung sowie das in erster Näherung gültige Ersatzbild zu erläutern,
- Fig. 6: anhand eines Funktionsblockdiagrammes das erfindungsgemässe Verfahren bzw. prinzipiell eine erfindungsgemässe Behandlungsanlage unter ihren beiden Aspekten in einer bevorzugten, prinzipiellen Realisationsform, wobei je unter I und II die bei dieser Anlage bevorzugterweise kombinierten erfinderischen Aspekte dargestellt sind,
- Fig. 7a bis 7c: schematisch drei Ausführungsbeispiele zur Beeinflussung des erfindungsgemäss genutzten Entladeverhaltens bzw. Umladeverhaltens durch externe Ladungseinspeisung, dargestellt anhand elektrischer Ersatzbilder,
- Fig. 8: ein Funktionsblock/Signalflussdiagramm einer bevorzugten Ausführungsvariante des erfindungsgemässen Vorgehens, bei welcher das Entladeverhalten gemessen wird und die Entladungszykluszeitspanne optimiert wird,
- Fig. 9: schematisch die Auswirkungen des Dickenwachstums einer nicht oder schlecht leitenden Schicht auf einer erfindungsgemäss genutzten, leitenden Fläche - der isolationsbelegten Fläche - auf die Entladezeitkonstante,
- Fig. 10: eine weitere Ausführungsvariante der Erfindung, bei welcher das Entladeverhalten gemessen, mit einem SOLL-Verhalten verglichen wird und in regelndem Sinne auf die Entladezyklus-Abfolge bzw. dessen -Länge eingegriffen wird und/oder zusätzlich Ladung in den Entladekreis eingekoppelt wird,
- Fig. 11: anhand eines Funktionsblock/Signalflussdiagrammes prinzipiell das erfindungsgemässe Vorgehen zur Steuerung einer Ladungsbelegung auf einer Isolationsbelegung, welche auf einer erfindungsgemäss in einen Entladestromkreis geschalteten, leitenden Fläche aufliegt,
- Fig. 12a bis 12c: eine bevorzugte Ausführungsvariante eines erfindungsgemässen Verfahrens zum reaktiven Ionenplattieren mit (Fig. 12b und 12c) je nach Betriebsphase der Anordnung nach Fig. 12a mindestens genähert gültigen Ersatzbildern,
- Fig. 13: eine erste bevorzugte Ausführungsvariante des Vorgehens bzw. der Anlage nach Fig. 12a,
- Fig. 14: schematisch anhand eines Funktionsblock/Signalflussdiagrammes eine weitere bevorzugte Ausführungsvariante des Vorgehens bzw. der Anlage nach den Fig. 12a bzw. 13, bei welcher die erwähnte Ladungsbelegung in Plattierungsphasen gesteuert wird,
- Fig. 15: anhand einer schematischen Anlagekonfiguration gemäss der vorliegenden Erfindung eine bevorzugte Potentiallegung einer Plasmaentladungsstreckenelektrode und einer erfindungsgemäss betriebenen, leitenden Fläche,
- Fig. 16: eine weitere bevorzugte Ausführungsvariante der vorliegenden Erfindung zum reaktiven Zerstäuben unter erfindungsgemässem Einsatz eines Gleichstromsignalgenerators,
- Fig. 17: schematisch, anhand eines Funktionsblock/Signalflussdiagrammes, eine weitere bevorzugte Ausführungsvariante des erfindungsgemässen Verfahrens bzw. einer erfindungsgemässen Behandlungsanlage, bei welchem die Häufigkeit bzw. die Art auftretender spontaner Entladeerscheinungen erfasst und in Funktion davon das erfindungsgemässe Entladen und/oder gegebenenfalls das erfindungsgemässe Ansteuern der aufgebrachten Ladungsbelegung in regelndem Sinne gestellt wird,
- Fig. 18: anhand eines schematischen Funktionsblock/ Signalflussdiagrammes das erfindungsgemässe Vorgehen bzw. eine erfindungsgemässe Anlage, woran mehrere Strecken elektrisch leitender Flächenpaare erfindungsgemäss, aber zeitgestaffelt betrieben werden,
- Fig. 19, 19a bis 19h: schematisch einige Ausführungsbeispiele des erfindungsgemässen Verfahrens bzw. erfindungsgemäss aufgebauter Behandlungsanlagen, in verschiedenen Konfigurationen.

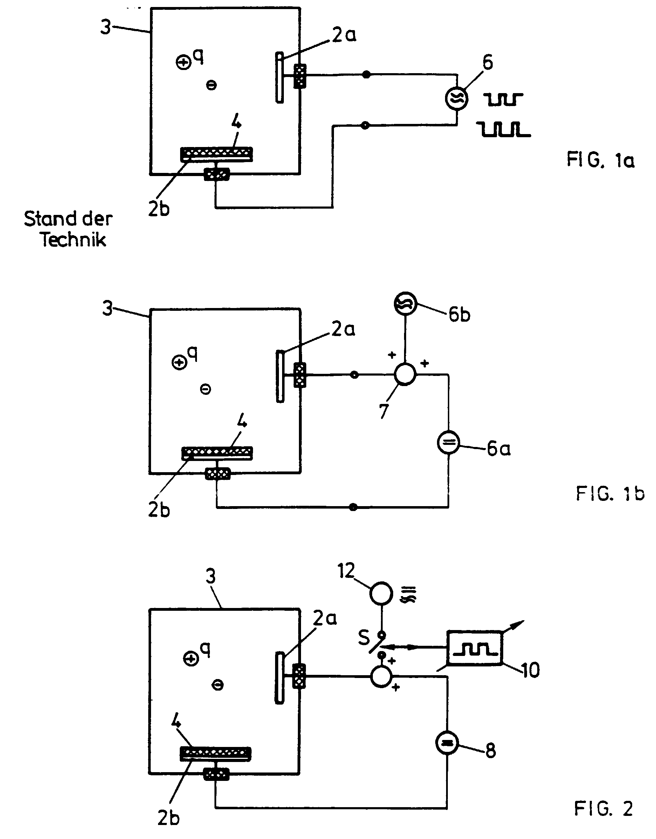

Die Figuren 1a und 1b stellen Vorgehensweisen bzw. Anlagekonfigurationen nach dem Stande der Technik dar.

In einem Vakuumrezipienten 3, in dessen Vakuumatmosphäre Ladungsträger q vorhanden sind, sollen leitende Flächen 2a und 2b, bzw. die zwischen ihnen liegende Vakuumatmosphärenstrecke, elektrisch betrieben werden, derart, dass ein elektrisches Feld zwischen den Flächen wirksam wird. Dabei ist mindestens eine der Flächen 2a und/oder 2b mindestens teilweise mit einer Belegung schlecht oder nicht leitenden Materials - weiterhin "Isolationsbelegung" genannt - versehen. Die Isolationsbelegung kann dabei eine vom Behandlungsprozess unabhängige Störschicht, wie eine Oxidationsschicht auf einer Metallfläche sein oder eine vorgängig auf einer leitenden Oberfläche aufgebrachte Schicht aus nicht oder schlecht leitendem Material oder eine während des betrachteten Behandlungsprozesses aufgebrachte Schicht aus dem genannten nicht oder schlecht leitenden Material, sei dies eine Schicht, die Ziel des Behandlungsprozesses ist, oder sei dies, während des Behandlungsprozesses, eine Störschicht.

Die Isolationsbelegung ist schematisch bei 4 eingetragen. Ausser im Falle, dass es sich bei der Isolationsbelegung 4 um eine Verunreinigungsschicht, wie um eine Oxidierungsschicht einer Metalloberfläche, die z.B. an Normalatmosphäre entstanden ist, handelt, wird eine solche Strecke zwischen den Flächen 2a und 2b, in einer ersten Variante, üblicherweise mit einem Wechselstromgenerator 6 betrieben, einem Generator, der im wesentlichen sinusförmige Ausgangssignale abgibt, oder, wie schematisch dargestellt, einen Impulszug, gegebenenfalls mit unterschiedlichen Tastverhältnissen (duty cycle).

Bei den genannten Verhältnissen zeigt Fig. 1b ein weiteres bekanntes Vorgehen, wonach dem Ausgangssignal eines Gleichstromgenerators 6a das Ausgangssignal eines Wechselstromgenerators 6b, wie bei 7 signaltechnisch dargestellt, überlagert wird. Dieses Vorgehen wird deshalb gewählt, weil bei Anlegen eines monopolaren, elektrischen Feldes zwischen den leitenden Flächen 2a und 2b sich an der Isolationsbelegung eine Ladungsbelegung aufbaut, beispielsweise bei negativ polarisierter Fläche 2b, positiver Ladungsträger, Ionen, und sich entsprechend, und wie noch beschrieben werden wird, über der Isolationsbelegung 4 eine Spannung aufbaut. Bei Erreichen entsprechender Spannungswerte treten lokal - den lokalen Verhältnissen entsprechend - spontane Entladeerscheinungen auf, sei dies durch die Isolationsbelegung hindurch, oberflächlich der Isolationsbelegung entlang, auf die Fläche 2b und/oder zu anderen benachbarten, entsprechend polarisierten Anlageteilen.

In Fig. 2 ist das erfindungsgemässe Vorgehen bzw. schematisch eine entsprechende erfindungsgemässe Anlage dargestellt. Die Flächen 2a und 2b werden erfindungsgemäss durch einen Gleichstromsignalgenerator 8 gespiesen. Dem Ausgangssignal des Gleichstromsignalgenerators 8 wird, mit vorgegebener Häufigkeit oder vorgebbarer Häufigkeit, und während vorgegebener Zeitabschnitte oder vorgebbarer Zeitabschnitte, gesteuert durch eine Taktgebereinheit 10, und wie mit dem Schalter S schematisch dargestellt, ein weiteres Signal aufgeschaltet, welches, wie schematisch dargestellt, durch eine wie auch immer geartete Signalerzeugungseinheit 12 bewirkt wird, so dass der Strecke zwischen den Flächen 2a und 2b zu den vorgegebenen bzw. vorgebbaren Zeiten und während der vorgegebenen bzw. vorgebbaren Zeitabschnitte ein vom Ausgangssignal des Generators 8 abweichendes Signal aufgeschaltet ist.

Bei der Einheit 12 kann es sich um einen eigens dafür vorgesehenen Signalgenerator handeln, welcher aber lediglich so ausgelegt sein muss, dass er entsprechend seiner Aufschalthäufigkeit und entsprechend den Aufschaltzeitspannen die geforderte Leistung an die Strecke zwischen den Flächen 2a und 2b liefern kann. Wie noch gezeigt werden wird, handelt es sich aber bevorzugterweise bei der Einheit 12 um eine Einheit, mittels welcher, im wesentlichen passiv, das Ausgangssignal des Gleichstromsignalgenerators 8, wie angegeben, in der Zeit gesteuert, verändert wird.

Fig. 2 zeigt den prinzipiellen, erfindungsgemässen Ansatz unter ihrem ersten Aspekt, nämlich unter demjenigen, dass die Strecke zwischen den genannten Flächen 2a und 2b elektrisch gespiesen werden muss, dies entsprechend ihrem Einsatz im Rahmen des beabsichtigten Behandlungsprozesses.

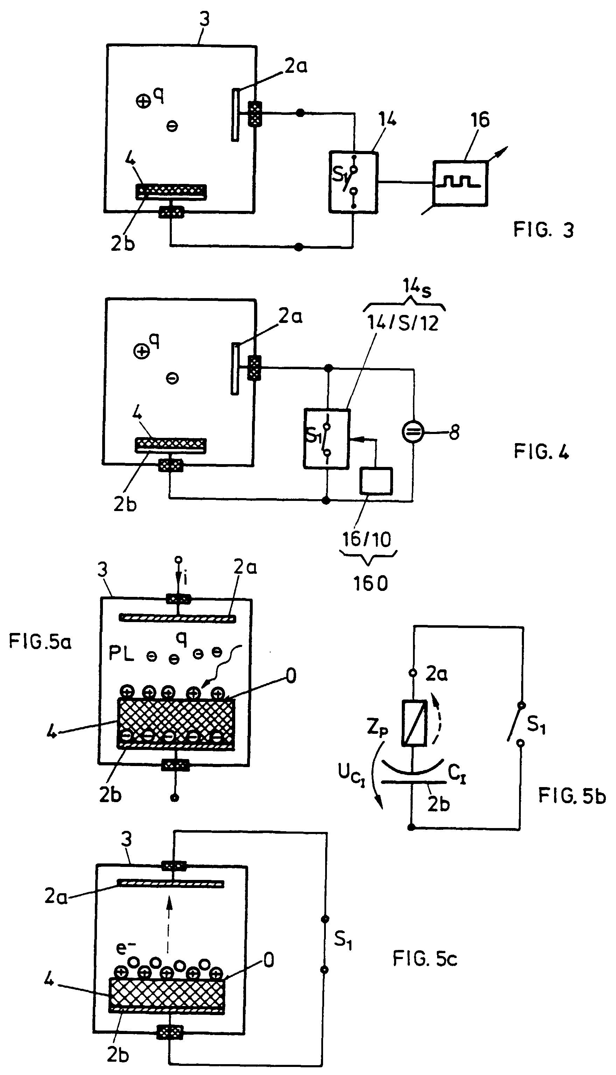

In Fig. 3 ist, in analoger Darstellung, das erfindungsgemässe Vorgehen bzw. eine entsprechende Anlage dargestellt unter dem zweiten erfindungsgemässen Aspekt, nämlich demjenigen, dass die beiden Flächen 2a, 2b elektrisch nicht gespiesen werden müssen, wie beispielsweise dann, wenn eine der Flächen in einem Plasmaentladungsprozess potentialschwebend betrieben wird. Erfindungsgemäss werden dann die beiden Flächen 2a und 2b, auf deren mindestens einer die Isolationsbelegung 4 aufliegt, über einen gesteuerten Entladestromkreis verbunden, wie dies in Fig. 3 mit der Entladeschalteinheit 14 dargestellt ist, welche durch eine Takteinheit 16 angesteuert wird. Daran ist die Frequenz, d.h. die Häufigkeit, mit welcher die Strekke zwischen den Flächen 2a und 2b mindestens kurzzeitig kurzgeschlossen wird, vorgegeben oder vorgebbar. Ebenso ist die Länge der Zeitabschnitte, während welchen der Entladestromkreis über die Einheit 14 durchgeschaltet wird, an der Einheit 16 vorgegeben oder daran vorgebbar.

Weder Häufigkeit noch Zeitabschnitte brauchen dabei während eines betrachteten Behandlungsprozesses in der Vakuumatmosphäre mit den Ladungsträgern q zeitkonstant zu sein, sondern beide Grössen können je nach Prozessverlauf und Prozessart in noch zu beschreibender Art und Weise geführt sein.

In Fig. 4 ist eine bevorzugte Ausführungsvariante des erfindungsgemässen Verfahrens bzw. einer entsprechenden Anlage dargestellt, bei welcher die Vorgehen bzw. die Anlagekonfigurationen gemäss den Fig. 2 und 3 kombiniert sind. Hierzu liegt wiederum die Durchschalteinheit 14 über der durch die Flächen 2a und 2b gebildeten Strecke, wird durch die Zeitsteuereinheit 16 angesteuert, und es liegt über der Durchschalteinheit 14 der Gleichstromsignalgenerator 8.

Wie nun ersichtlich, wird in höchst vorteilhafter Weise die Durchschalteinheit 14 sowohl im Sinne einer Entladestromkreis-Durchschalteinheit wie auch als Schalteinheit S gemäss Fig. 2 eingesetzt, mittels welcher das Ausgangssignal des Gleichstromsignalgenerators 8 mit vorgegebener oder vorgebbarer Häufigkeit und während vorgegebener oder vorgebbarer Zeitabschnitte verändert wird. Dementsprechend wirkt die Takteinheit 16 gleichzeitig als Takteinheit 10 gemäss Fig. 2 und die Durchschalteinheit 14 selbst als Schalteinheit S und als Einheit 12 gemäss Fig. 2, zur Erzeugung des vom Ausgangssignal des Generators 8 abweichenden Signals.

In dieser kombinierten Funktion werden im weiteren die Durchschalteinheit 14 mit dem Bezugszeichen 14_{S} und die Takteinheit 16 mit dem Bezugszeichen 160 bezeichnet.

Das Prinzip, das durch die vorliegende Erfindung unter ihren beiden Aspekten, insbesondere aber unter dem zweiten, berücksichtigt ist, soll, ohne Anspruch auf physikalische Exaktheit, anhand der Fig. 5a bis 5c erläutert werden.

In Fig. 5a ist schematisch der Vakuumrezipient 3 dargestellt, darin, in der Vakuumatmosphäre, die Ladungsträger q, beispielsweise und insbesondere erzeugt durch eine Plasmaentladung PL. Es sind wiederum die beiden erfindungsgemäss betriebenen, leitenden Flächen 2a und 2b eingetragen sowie eine Isolationsbelegung 4. Es werde nun die Oberfläche O der Isolationsbelegung 4 ladungsbelegt, insbesondere mit den schematisch dargestellten positiven Ionen.

Es bildet sich auf der der Elektrode 2b zugewandten Oberfläche der Isolationsbelegung 4 eine der äusseren Ladungsbelegung gegengleiche Ladungsbelegung, wie schematisch dargestellt. Die Isolationsbelegung 4 bildet das Dielektrikum eines im Ersatzbild gemäss Fig. 5b mit C_{I} eingetragenen Kondensators, dessen eine Platte durch die Fläche 2b gebildet wird, dessen andere durch die Oberfläche O, angrenzend an die aufgrund der Ladungsträger q leitende Strecke der Vakuumatmosphäre.

Diese Vakuumstrecke kann grundsätzlich mit der Impedanz Z_{P} dargestellt werden, wobei mindestens in erster Näherung diese Impedanz als ohmisch betrachtet werden kann. Dies, weil die beweglichen Elektronen in der Vakuumatmosphäre in erster Näherung Proportionalität zwischen Feldstärke und Ladungsverschiebung gewährleisten.

Erfindungsgemäss, nämlich nach dem erfindungsgemässen zweiten Aspekt gemäss Fig. 3, wird die Vakuumatmosphärenstrecke zwischen den Flächen 2a und 2b intermittierend kurzgeschlossen. Wenn eine Ladungsbelegung wie in Fig. 5a stattgefunden hat, so liegt über dem Kondensator C_{I} eine Spannung gemäss U_{CI}, wie in Fig. 5b eingetragen. Wird die Schaltstrecke S₁ entsprechend der Durchschalteinheit 14 von Fig. 3 geschlossen, so muss weiterhin die Summe aller Spannungen im Entladestromkreis verschwinden. Es stellt sich rasch die in Fig. 5c vereinfacht dargestellte Situation ein: Bei Schliessen der Schaltstrecke S₁ baut sich vorerst über der Impedanz Z_{P} die in Fig. 5b gestrichelt eingetragene Spannung auf, die ebenfalls in Fig. 5c eingetragen ist, und wodurch rasch bewegliche Elektronen gegen die Oberfläche O hin getrieben werden. Dadurch bildet sich, angrenzend an diese Oberfläche, eine elektrische Doppelschicht aus, ohne wesentliche Aenderung der Ionenladungsbelegung, welche Doppelschicht als Ganzes ladungsneutral ist.

Mithin wird durch Schliessen der Schaltstrecke S₁ die Ladungsbelegung neutralisiert, ohne dass aber dabei die Ionenbelegung wesentlich gestört würde. Anlass zu Problemen gibt aber die elektrische Ladungsbelegung gemäss Fig. 5a, die dann, wenn die entsprechende Spannung Durch- oder Ueberschlagswerte erreicht, zu den geschilderten spontanen Entladeerscheinungen führt.

Es sei bereits an dieser Stelle erwähnt, dass durch das beschriebene Vorgehen, abgesehen von der Lösung der erwähnten, sich durch Spontanentladungen ergebenden Probleme, überhaupt erst ermöglicht wird, auf nicht oder schlecht leitende Schichten - oder Oberflächen generell -, im Sinne der erwähnten Isolationsbelegung, Schichten durch Ionenplattieren aufzubringen oder auf leitenden Oberflächen nicht oder schlecht leitende Schichten im Sinne der erwähnten, im Prozess entstehenden Isolationsbelegung, aufzubringen.

Die Zeitkonstante des bei Schliessen der Schaltstrekke S₁ aufgrund des heuristisch erläuterten Mechanismus eintretenden "Entladevorganges" bzw. "Umladevorganges" ist im wesentlichen gegeben durch den Kapazitätswert des Kondensators C_{I} und den im wesentlichen durch die Elektronenbeweglichkeit gegebenen "Widerstandswert", der mit Ladungsträgern versehenen Vakuumatmosphäre, entsprechend der Impedanz Z_{P}. Diese Zeitkonstante kann selbstverständlich durch externe Beschaltung des Entladestromkreises beeinflusst werden, sei dies durch Vorsehen gegebenenfalls variabler Widerstandselemente, erforderlichenfalls kann der Entladestromkreis vorerst genähert erster Ordnung, durch Zuschalten von weiteren Impedanzelementen, wie von Induktivitäten, zu einem System zweiter Ordnung ausgebaut werden.

Im Rahmen der vorliegenden Erfindung ist aber vorerst wichtig, dass die nach einem Entladevorgang verbleibende Ladungsbelegung am Kondensator C_{I} durch Zuschalten von ladungstreibenden Quellen in den Entladungskreis beeinflusst werden kann, und weiter, insbesondere mit Blick auf das erwähnte Ionenplattieren, dass während Phasen, in welchen die Schaltstrecke S₁ geöffnet ist, durch externe Ladungseinspeisung in die Strecke zwischen den Flächen 2a und 2b, wie noch erläutert werden wird, der Ladungsbelegungsaufbau gesteuert bzw. gestellt werden kann.

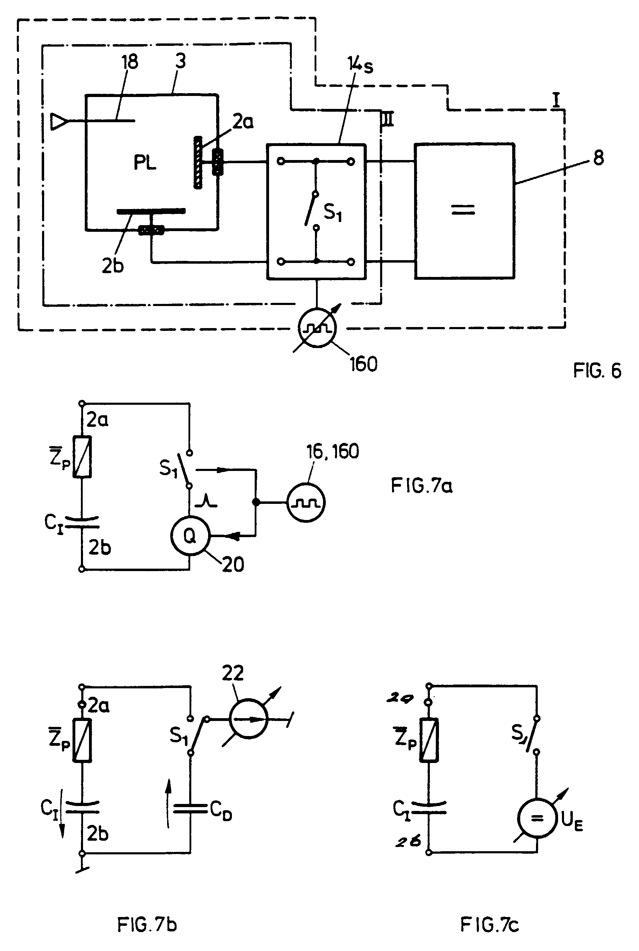

Bevor weiter auf bevorzugte Ausführungsvarianten eingegangen wird, sei anhand von Fig. 6 nochmals mit Blick auf die Fig. 2 bis 4 das Konzept der vorliegenden Erfindung unter ihren verschiedenen Aspekten erläutert.

In Fig. 6 sind die erfindungsgemässen Verfahren bzw. sind erfindungsgemässe Anlagen unter ihren beiden Aspekten und in bevorzugten Realisationsformen schematisch dargestellt. Der Vakuumrezipient 3, worin bevorzugterweise eine Plasmaentladung PL unterhalten wird, ist gegebenenfalls mit einem Einlass 18 für ein Reaktivgas oder Reaktivgasgemisch versehen. Zwischen den leitenden Flächen 2a und 2b, bzw. über der zwischen ihnen im Vakuumrezipienten 3 gebildeten Strekke, ist in einer bevorzugten Ausführungsvariante des Vorgehens bzw. der Anlage gemäss Fig. 4 die als Zerhackereinheit wirkende Einheit 14_{S} geschaltet, im weiteren, über der Zerhackereinheit 14_{S} der Gleichstromsignalgenerator 8. Die Zerhackereinheit 14_{S} wird durch den bevorzugterweise gesteuerten Taktgeber 160 angesteuert. Die Zerhackereinheit 14_{S}, vorzugsweise gebildet mit elektronischen Schaltelementen, wie Schalttransistoren, MOSFETS, Thyratrons, Thyristoren, spark gaps, gesättigten Drosseln etc., liegt, wie erwähnt, parallel über den leitenden Flächen 2a, 2b und der zwischen ihnen liegenden Strecke und bildet den Entladestromkreis über besagte Strecke.

Wie dem Fachmann geläufig, sind gegebenenfalls, und wie noch spezifisch zu beschreiben sein wird, Vorkehrungen getroffen, um beim Durchschalten der Schaltstrecke S₁ an der Zerhackereinheit 14_{S} den Gleich-stromsignalgenerator 8 nicht einfach kurzzuschliessen.

Unter dem ersten Aspekt (I), in Fig. 6 gestrichelt unter I umrandet, umfasst die Erfindung mithin die einfache Kombination eines Gleichstromsignalgenerators 8 und einer Kurzschluss-Zerhackereinheit 14_{S}, worüber die Strecke zwischen den Flächen 2a und 2b an der Vakuumbehandlungsanlage elektrisch betrieben wird. Dabei kann eine bestehende gleichstromgeneratorbetriebene Anlage durch Vorsehen der Zerhackereinheit 14_{S} in einfacher Art und Weise zur Durchführung mit der Gleichstromspeisung nicht oder nur schlecht durchführbarer Behandlungsverfahren ausgebaut werden.

Unter dem zweiten Aspekt (II) umfasst die Erfindung, wie bereits erwähnt wurde, auch ausschliesslich das Vorsehen der Zerhackereinheit 14_{S}, die gegebenenfalls auch zwischen Elektroden vorgesehen werden kann, die nicht elektrisch gespiesen werden, sondern deren eine beispielsweise auf Bezugspotential gelegt ist, wie auf Massepotential, und deren zweite normalerweise potentialschwebend betrieben wird und sich ihr Potential gemäss der Potentialverteilung in der Vakuumatmosphäre einstellt. Auch bei derartigen Strecken zwischen leitenden Flächen 2a, 2b kann es durchaus erwünscht sein, Ladungsbelegungen abzubauen, welche das Schwebepotential der einen leitenden Fläche bzw. Elektrode beeinflussen, so dass das erfindungsgemässe Entladen mit der Zerhackereinheit 14_{S} als für sich erfinderischen Teil der vorliegenden Erfindung betrachtet wird. Dieser Teil der vorliegenden Erfindung ist in Fig. 6 strichpunktiert umrandet und mit II bezeichnet.

In Fig. 7a ist das Vorsehen einer Ladungsquelle in dem anhand von Fig. 5 beschriebenen, erfindungsgemäss vorgesehenen Entladekreis dargestellt, welche Ladungsquelle in Entladephasen, d.h. bei durchgeschalteter Schaltstrecke S₁, auf die Strecke zwischen den Flächen 2a und 2b geschaltet ist. Hierzu wird in den erwähnten Entladestromkreis beispielsweise eine Ladungsquelle 20, beispielsweise in Form einer Stromimpulsquelle, geschaltet, ausgelöst bzw. gesteuert, wie schematisch dargestellt, im wesentlichen synchron mit dem Schliessen der Schaltstrecke S₁ durch den Taktgeber 16 bzw. 160, je nachdem, ob die in Fig. 7a dargestellte Konfiguration, wie in Fig. 3 dargestellt, oder in der Kombinationskonfiguration, wie grundsätzlich in Fig. 4 bzw. 6 dargestellt, eingesetzt wird.

Damit wird bei Schliessen der Schaltstrecke S₁ Ladung mit vorgegebener Polarität auf den Kondensator C_{I} aufgebracht und die Ladungsbelegung zu Beginn eines Entladezyklus nach Wunsch erhöht oder erniedrigt. Insbesondere kann dadurch der Entladezyklus verkürzt werden, indem, im Extremfall, durch die extern aufgebrachte Ladung die gesamte Ladungsbelegung am Kondensator C_{I} neutralisiert werden kann.

Dabei ist jedoch zu beachten, dass dann, wenn weiterhin ein selbständiger Entladevorgang im erwähnten Entladestromkreis beabsichtigt ist, die Impedanz im Entladekreis durch Einführung der Ladungsquelle 20 nicht unzulässig erhöht werden darf, um die Entladezeitkonstante nicht über das erwünschte Mass zu erhöhen.

In Fig. 7b ist eine erste Ausführungsvariante dargestellt, um die externe Aufladungsbeeinflussung des Kondensators C_{I} gesteuert vorzunehmen. Bei geöffneter Schaltstrecke S₁ wird eine diskrete Kapazität C_{D} durch eine Stromquelle 22 mit erwünschter Polarität, wie beispielsweise eingetragen, aufgeladen.

Wird die Schaltstrecke S₁ durchgeschaltet, so ergibt sich nun das Entlade- bzw. Umladeverhalten des Gesamtkreises aus dem Verhältnis der Kapazitätswerte von C_{I} und C_{D} sowie den jeweiligen Aufladeverhältnissen als Anfangsbedingungen, wie dies dem Fachmann durchaus geläufig ist.

Wird in Phasen, in denen S₁ offen ist, die Ladung, die sich an C_{I} aufbaut, erfasst, so kann mit der hier beschriebenen Ladungsquelle diese Ladung neutralisiert werden. Gegebenenfalls kann dann die Schaltstrecke S₁ entfallen; in den einen Phasen wird die Ladungsbelegung erfasst, in den anderen neutralisiert.

Bei der in Fig. 7c dargestellten bevorzugten Ausführungsvariante wird in den Entladestromkreis eine Spannungsquelle U_{E} geschaltet, derart, dass sich das Entladeverhalten aufgrund der Differenz zwischen der Ladespannung an C_{I} und U_{E} ergibt. Damit kann durch Betrag und Polarität der Spannung U_{E} das Entlade- bzw.- Umladeverhalten des Kondensators C_{I} beeinflusst werden. Bevorzugterweise wird das Entladeverhalten dadurch in gewissen Fällen beschleunigt, in dem Sinne, dass eine vorgegebene, verbleibende Ladespannung an C_{I} schneller erreicht wird, als wenn die betrachtete Strecke nur direkt kurzgeschlossen wird.

Ein wesentlicher Vorteil des erfindungsgemäss ausgenutzten Entladeverfahrens besteht darin, dass der Entlade- bzw. Umladevorgang messtechnisch verfolgt werden kann. Dies bevorzugterweise durch Strom- oder Ladungsmessung im Entladestromkreis.

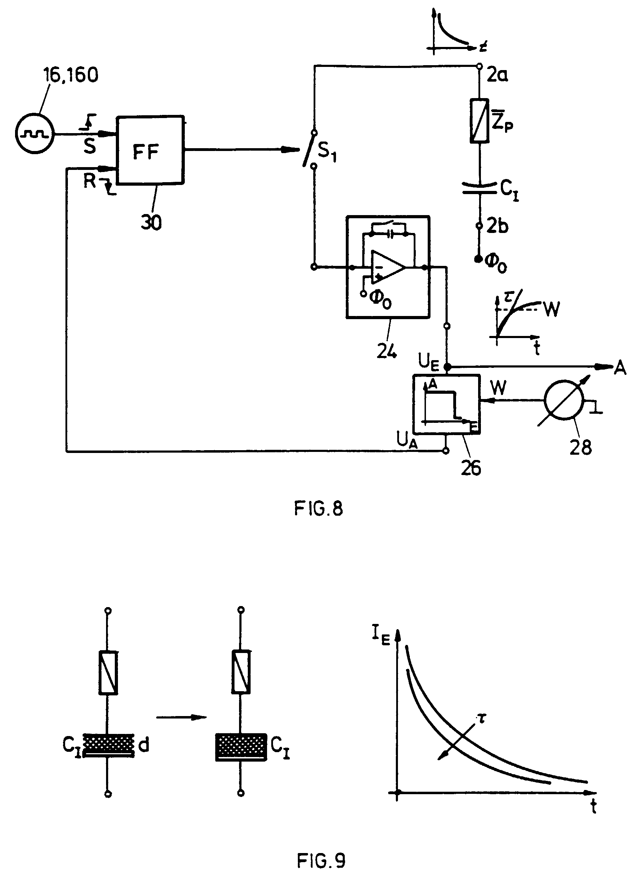

Dies soll beispielsweise anhand von Fig. 8 erläutert werden. Demnach wird die leitende Fläche 2b der betrachteten Strecke auf ein Bezugspotential Φₒ gelegt und die Strecke über die Schaltstrecke S₁ an den invertierenden Eingang eines Strom- oder, wie dargestellt, Ladungsverstärkers bekannter Bauart, wie bei 24 dargestellt, geführt. Wie weiter beispielsweise dargestellt, ist der hierzu verwendete Differentialverstärker mit seinem positiven Eingang auf das Bezugspotential Φₒ gelegt. Bei Durchschalten der Schaltstrecke S₁ erscheint in der dargestellten Konfiguration ausgangsseitig des Messverstärkers 24 das Integral des Entladestromstosses, wie schematisch über der Zeitachse t dargestellt. Wie bei A dargestellt, kann das Messresultat des Entlade- bzw. Umladeverhaltens zu verschiedenen, noch zu diskutierenden Zwecken ausgewertet werden.

Gemäss Fig. 8 wird es bevorzugterweise einer Komparatoreinheit 26 zugeführt, welcher von einer Referenzsignalquelle 44 der Schwellwert W vorgegeben wird. Erreicht das Ausgangssignal des Verstärkers 24 den eingestellten Schwellwert W, womit entsprechend der Entladevorgang auf einen entsprechenden, vorgegebenen Wert abgeklungen ist, so wird z.B ein bistabiles Element 30 rückgesetzt und die Schaltstrecke S₁ geöffnet. Das bistabile Element kann dabei durch die aufsteigende Schaltflanke des Taktgebers 16 bzw. 160 gesetzt und damit die Schaltstrecke S₁ durchgeschaltet werden.

Damit wird erreicht, dass der Entladezyklus nur gerade so lange währt, wie dies zum Erreichen eines vorgegebenen Entladezustandes notwendig ist. Damit werden nur geringstmögliche Zeitabschnitte für diesen Entladevorgang blockiert, und die übrige Zeit steht, insbesondere bei Einsatz der Anordnung gemäss Fig. 8 in der Konfiguration gemäss Fig. 4, für die Energieeinspeisung ab Gleichstromsignalgenerator 8 zur Verfügung.

Wie ohne weiteres ersichtlich, ist die Zeitkonstante τ des Entladevorganges massgeblich vom Kapazitätswert des Kondensators C_{I} abhängig. Wenn das erfindungsgemässe Vorgehen an der Strecke zwischen den leitenden Flächen 2a und 2b eingesetzt wird, innerhalb welcher ein Werkstück mit einer nicht oder schlecht leitenden Oberfläche im Sinne einer Isolationsbelegung angeordnet ist, wie beispielsweise ein Werkstück, das durch einen reaktiven Beschichtungsprozess mit einer "Isolationsbelegung" als gewollte Schicht belegt wird, so fällt mit zunehmender Schichtdicke der Kapazitätswert von C_{I} mit der bekannten Abstandsrelation des Kapazitätswertes.

Somit kann, wie in Fig. 9 schematisch dargestellt, durch Auswertung des Signals A von Fig. 8 die sich mit ändernder Schichtdicke d abnehmende Entladezeitkonstante τ ermittelt werden und daraus auf das Schichtwachstum geschlossen werden.

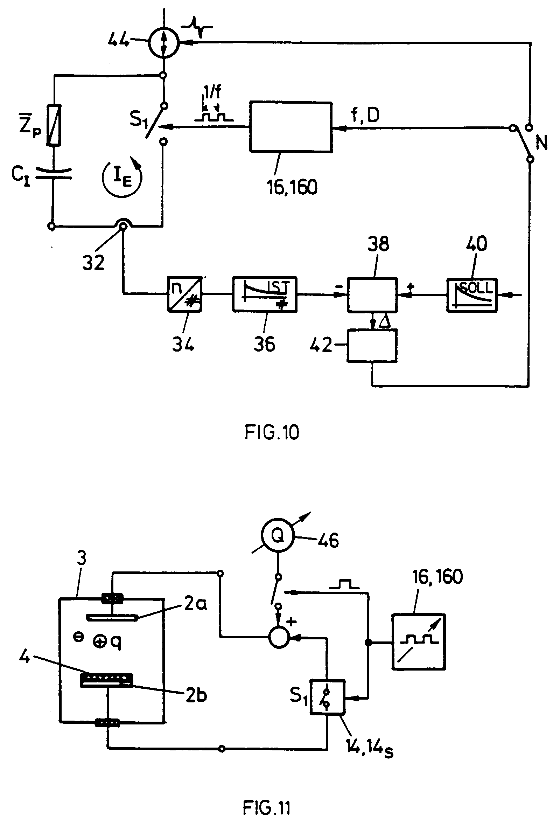

In Fig. 10 ist eine weitere Ausführungsvariante dargestellt, wonach durch Ermittlung des IST-Entladeverhaltens, anschliessendem Vergleichen mit einem SOLL-Verhalten, entsprechend dem Vergleichsresultat, in regelndem Sinne so auf den Betrieb der Schaltstrecke S₁ eingegriffen wird, dass sich die Entladeverhalten, mindestens genähert, um das SOLL-Verhalten einpendeln. Hierzu wird, wie schematisch dargestellt, der Entladestrom I_{E} abgegriffen, wie bei 32 dargestellt, und ein entsprechendes Spannungssignal, z.B. digitalisiert, mittels eines Analog/Digital-Wandlers 34. Das digitalisierte Messignal wird in einer IST-Wert-Speichereinheit 36 abgespeichert. Der Inhalt der IST-Wert-Speichereinheit 36 wird, an einer Vergleichseinheit 38, mit einem in einer SOLL-Wert-Speichereinheit 40 abgespeicherten SOLL-Entladeverlauf verglichen.

An einer Auswerteeinheit 42 werden Differenzen Δ zwischen SOLL-Verlauf und IST-Verlauf ausgewertet und mit dem Auswertungsresultat, ausgangsseitig der Auswerteeinheit 42, wie schematisch mit dem Umschalter N dargestellt, entweder auf eine gesteuerte, in ihrer Polarität umkehrbare Ladungsquelle 44 eingewirkt, um den jeweiligen Ladezustand des Kondensators C_{I} bei geöffneter Schaltstrecke S₁ zu beeinflussen, damit seine Ladungsbelegung, oder es wird mit dem Ausgang der Auswerteeinheit 42, an der Taktgebereinheit 16 bzw. 160, die Folgefrequenz f sich folgender Entladezyklen vergrössert oder verkleinert oder bei gleichbleibender Repetitionsfrequenz f das Tastverhältnis (duty cycle) der ausgangsseitig des Taktgebers 16 bzw. 160 die Schaltstrecke S₁ ansteuernden Impulszuges. Wird, durch Ansteuerung der Ladungsquelle 44, das Entladeverhalten zum Verschwinden gebracht, so heisst dies, dass die Ladungsbelegung durch Wirkung der Quelle 44 elektrisch neutralisiert ist. Auch dies kann durch den dargestellten Regelkreis erzielt werden.

Beispielsweise kann wie folgt zyklisch vorgegangen werden:
a) Schalter S₁ öffnen; Quelle 44 treibt Ladung auf C_{I}, welcher der Aufbau einer Ladungsbelegung entspricht.
b) Schalter S₁ weiterhin offen: Quelle 44 wird während kurzer Zeit invertiert betrieben, die entstandene Ladungsbelegung wird elektrisch gesteuert neutralisiert.
c) Schalter S₁ wird geschlossen, der Entladestrom gemessen; je nach seiner verbleibenden Grösse und Polarität wird, geregelt, die Neutralisationsladung in Schritt b) gestellt und/oder die Ladungsbelegungssteuerladung in Schritt a).

Auf das erwähnte externe Aufschalten einer Ladungsquelle, wie beispielsweise der Quelle 44, in Phasen, in welchen die Schaltstrecke S₁ geöffnet ist, wird im Zuge der vorliegenden Beschreibung noch weiter eingegangen. Dies insbesondere im Zusammenhang mit Ionenplattieren als Teil des erfindungsgemässen Verfahrens.

Es kann durch Eingriffnahme auf den Ladungszustand des Kondensators und/oder auf die Entladehäufigkeit bzw. auf die Länge der Entladezyklen so auf die Ladungsbelegung des Kondensators C_{I} eingegriffen werden, in regelndem Sinne, dass bei zeitkonstantem Kapazitätswert von C_{I} das Entladeverhalten und mithin die Ladungsbelegung einem SOLL-Wert folgt. Dies auch dann, wenn die Entladezeitkonstante mit variierendem Kapazitätswert von C_{I} variiert, indem dann, aus der Entladezeitkonstanten τ, auf den momentanen Wert des erwähnten Kondensators geschlossen wird und von diesem und dem Anfangswert des Entladevorganges auf die Ladungsbelegung an C_{I}.

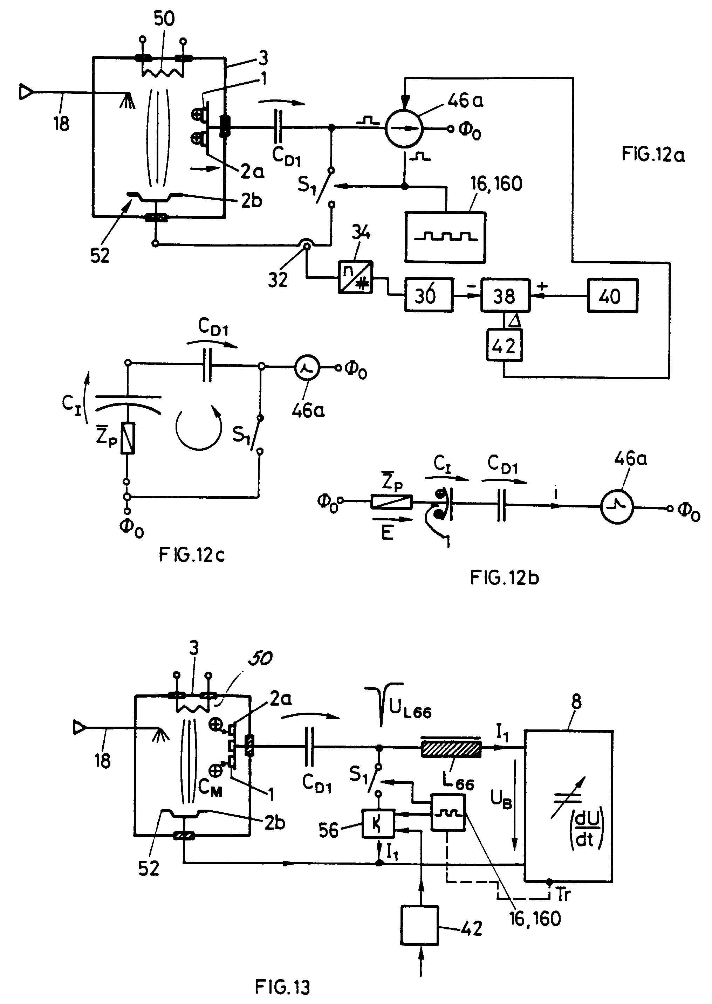

In Fig. 11 ist, ausgehend von der Darstellung gemäss Fig. 3 oder in der kombinierten Konfiguration gemäss Fig. 4, dargestellt, wie grundsätzlich gemäss einem Aspekt der vorliegenden Erfindung in Zeitabschnitten zwischen Entladezyklen die Ladungsbelegung der Isolationsbelegung 4 in steuerndem, gegebenenfalls regelndem Sinne beeinflusst werden kann.

Dazu sei zuerst noch einmal Fig. 5 betrachtet. Wenn in Fig. 5, extern der Strecke zwischen den Flächen 2a und 2b, eine Ladung aufgezwungen wird, so wird der Kondensator C_{I} aufgeladen. Wird, üblicher Stromrichtungskonvention folgend, in eingetragener Richtung, ein Strom i, entsprechend einer Ladung pro Zeiteinheit, aufgezwungen, so ergibt dies eine Zunahme der Ladungsbelegung mit positiven Ionen an der Isolationsbelegung 4 und, entsprechend, eine Abnahme dieser Belegung an der Isolationsbelegung 4, d.h. ein Abwandern positiver Ionen bzw. ein Zuwandern von Elektronen bei Stromumkehr. Es sei darauf hingewiesen, dass üblicherweise die Stromrichtung i entgegen dem Elektronenstrom eingezeichnet wird.

Damit kann durch externe Aufschaltung eines Stromes bzw. einer Ladung die Ladungsbelegung an der Isolationsbelegung gesteuert werden. Dies ist von ausserordentlicher Wichtigkeit, insbesondere bei all denjenigen Behandlungsverfahren, an welchen mit einer Ladungsbelegung, und damit Materialbelegung, eine Schicht aufgebracht werden soll, wie insbesondere beim Ionenplattieren. Dort werden Ionen aus der Vakuumatmosphäre gezielt auf ein Werkstück mittels elektrostatischer Kräfte abgelegt.

Gemäss Fig. 11 wird zu diesem Zweck, bei geöffneter Schaltstrecke S₁, an der Einheit 14 bzw. 14_{S} gemäss den Fig. 3 oder 4, mit der Takteinheit 16 bzw. 160, ein Ladungsfluss durch die Strecke mit den leitenden Flächen 2a und 2b getrieben, wie dies schematisch in Fig. 11 mit der Ladungsquelle 46 dargestellt ist, welche synchron mit der Durchschaltung der Schaltstrecke S₁ betrieben wird.

Damit kann bei den genannten Verfahren, wie insbesondere auch bei Ionenplattieren, der Aufbau einer Schicht auf der nicht oder schlecht leitenden Oberfläche eines Werkstückes oder einer Schicht aus nicht oder schlecht leitendem Material auch auf die leitende Oberfläche eines Werkstückes gezielt beeinflusst bzw. gesteuert bzw. geregelt werden.

In Fig. 12a bis 12c ist schematisch eine bevorzugte Ausführungsvariante dieses erfindungsgemässen Verfahrens bzw. einer entsprechend aufgebauten Anlage dargestellt. Im Vakuumrezipienten 1 wird von einem Tiegel 52, z.B. mit einer Plasmaentladung, Material in bekannter Art und Weise verdampft. Dies kann mittels Bogenentladung bzw. Funkenentladung auf den Tiegel 52 erfolgen oder durch Elektronenstrahlverdampfen des Materials im Tiegel 52 oder, wie dargestellt, mittels einer Niederspannungsglimmentladung zwischen einer Glühemissionskathode 50 und dem Tiegel 52. Selbstverständlich kann das Material auch durch Tiegelheizung verdampft werden oder auch zerstäubt werden. Wesentlich ist nur seine Ionisation, gleich welcher Art die eigentliche Materialquelle ist und ob der Prozess, der das Schichtmaterial bildet, reaktiv ist oder nicht.

Durch die Gaszuleitung 18 wird beim dargestellten Beispiel ein Arbeitsgas in den Vakuumrezipienten 1 eingelassen mit Reaktivgasanteilen, welche, in der Glimmentladung, mit dem aus dem Tiegel 52 verdampften Material reagieren. Es bilden sich Ionen. Als Reaktionsprodukt legt sich schlecht oder nicht leitendes Material in Form positiver Ionen, vorerst als Ladungsbelegung, auf ein oder mehrere Werkstücke 1 ab, auf der als Werkstückträgerelektrode ausgebildeten, leitenden Fläche 2a. Die Werkstücke 1 weisen dabei entweder eine leitende Oberfläche auf und werden durch das Plattierverfahren mit einer Schicht nicht oder schlecht leitenden Materials belegt oder weisen bereits eine Oberfläche aus nicht oder schlecht leitendem Material auf und werden dann mit einer Schicht ebenfalls nicht oder schlecht leitenden Materials oder mit einer Schicht leitenden Materials belegt.

Das Verfahren lässt einerseits Ionenplattieren mit nicht oder schlecht leitenden Schichten auf beliebig leitenden oder nicht leitenden Oberflächen zu oder Ionenplattieren mit leitenden Schichten auf nicht oder schlecht leitenden Schichten am Werkstück bzw. auf nicht oder schlecht leitenden Werkstücken. Solche Schicht/Werkstücksysteme liessen sich bisher mit Ionenplattieren nur höchst eingeschränkt herstellen, da der notwendige, monopolare Plattierungsstrom gar nicht aufgebaut werden konnte.

Im weiteren können, wie ohne weiteres ersichtlich, Werkstücke 1 in dieser noch weiter zu beschreibenden Anlagenkonfiguration mit Mehrschichtsystemen beaufschlagt werden, insbesondere können Werkstücke aus bezüglich Leitfähigkeit beliebigem Material mit einer nicht oder schlecht leitenden ersten Schicht, insbesondere als Korrosionsschutzschicht, versehen werden, mit einer leitenden zweiten Schicht, insbesondere als Verschleissschutzschicht, oder mit Kombinationen derartiger Schichten, wobei mehr als nur zwei Schichten aufgebaut werden können.

Wesentlich für das Ionenplattieren ist, dass das abzulegende Schichtmaterial, wie erwähnt, in der Vakuumkammer ionisiert wird. Dies kann auf die unterschiedlichsten Arten erfolgen, wie z.B. bei Elektronenstrahlverdampfen durch Vorsehen einer Plasmaentladung, wie einer Bogenentladung auf den Tiegel. Die Ionisierung erfolgt beim Lichtbogenverdampfen oder Glimmentladungsverdampfen durch die Plasmaentladung selbst, oder es kann durch Einkoppeln zusätzlicher Elektronen oder Ionen in den Vakuumrezipienten die notwendige Ionisation erwirkt werden. Im weiteren braucht nicht zwingend ein Reaktivprozess vorgesehen zu sein, wenn beispielsweise das verdampfte Material als solches, nach Ionisierung, abgelegt werden soll.

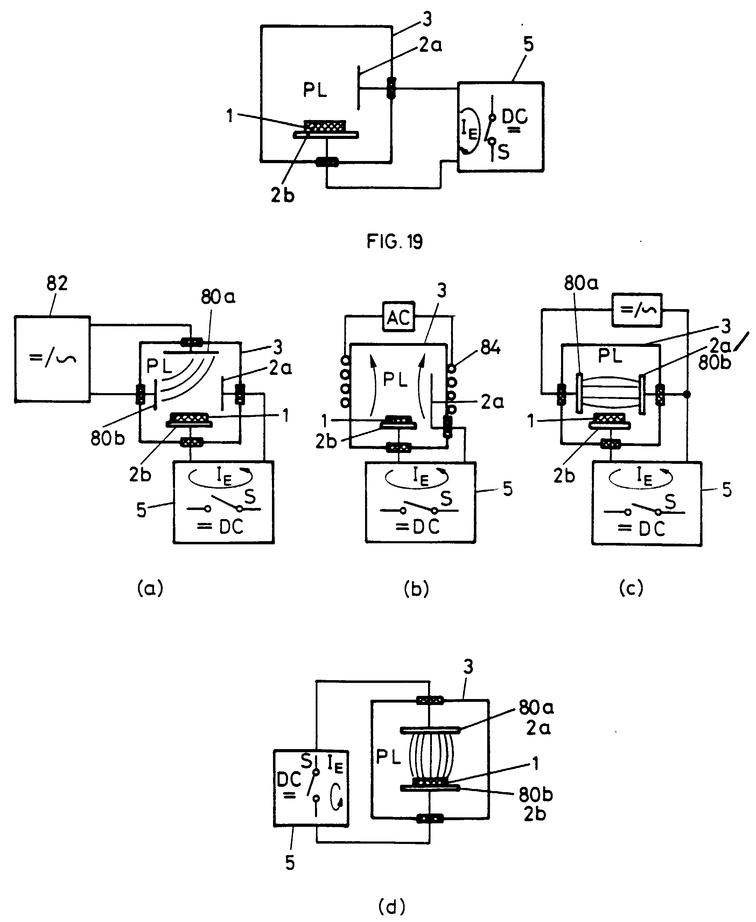

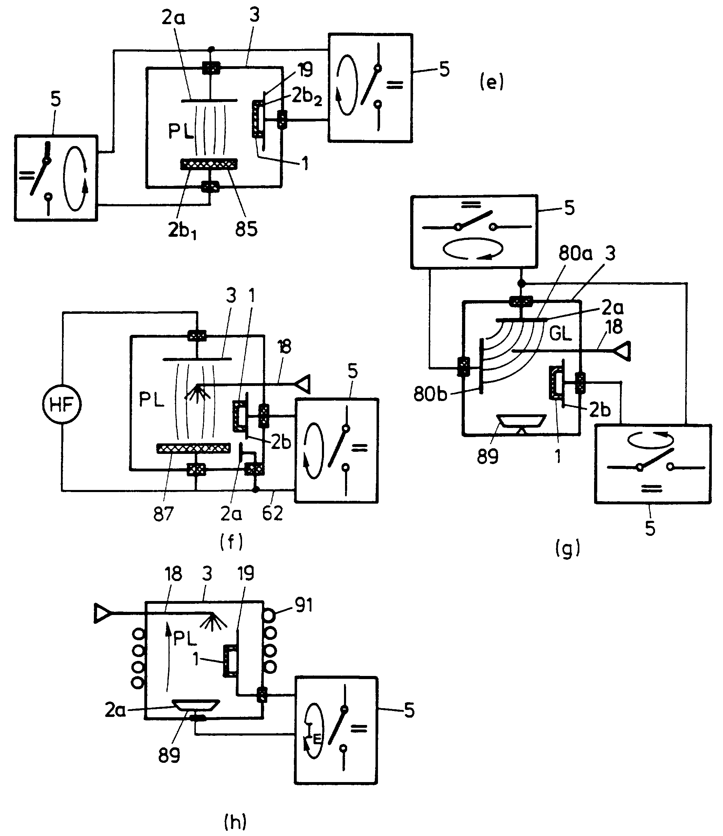

Weiter kann, anstelle des Verdampfens, Material gesputtert werden. Wird ein leitendes Material gesputtert, so kann die Sputterquelle, wie eine Magnetronquelle, anstelle des Tiegels 52 vorgesehen werden. Soll ein nicht leitendes Material gesputtert werden, so wird bevorzugterweise die Sputterquelle separat mittels einer Hochfrequenzentladung betrieben und dann anstelle des Tiegels 52 für die erfindungsgemässe weitere Beschaltung eine von der Entladung unabhängige, leitende Fläche als Bezugsfläche im Rezipienten vorgesehen (s. Fig. 19f).

In jedem Fall ist die als Werkstückträgerelektrode wirkende leitende Fläche 2a beim Ionenplattieren so auf Potential zu legen, dass positive Ionen als Ladungsbelegung gegen die Werkstücke 1 hin beschleunigt werden. Der Leistungsbedarf der elektrischen Speisung für die beschriebene Strecke, zwischen leitender Fläche 2a und leitender Fläche 2b, ist wesentlich geringer als der Leistungsbedarf zum Unterhalt einer gegebenenfalls vorgesehenen Plasmaentladung.

Bei Ausbildung gemäss den Ausführungen zu Fig. 11 entspricht der extern zuzuführende Plattierungsstrom der durch Ionen- und Elektronenwanderung zwischen den Flächen 2a und 2b verschobenen Ladung. Mindestens einer der leitenden Flächen 2a bzw. 2b, bevorzugterweise der als Werkstückträgerelektrode wirkenden Fläche 2a, gemäss Fig. 12a, wird eine diskrete Kapazität C_{D1} vorgeschaltet. Die Schaltstrecke S₁ schaltet den Entladestromkreis zur zweiten leitenden Fläche 2b durch, dem Tiegel, im Falle des Verdampfens oder der Sputterquelle, im Falle des Sputterns eines leitenden oder halbleitenden Materials. Es wird eine Strom- bzw. Ladungsquelle 46a (vgl. auch Fig. 11) vorgesehen, welche, bei geöffneter Schaltstrecke S₁, wie aus Fig. 12b ersichtlich, mit der diskreten Kapazität C_{D1}, dem Streckenkondensator C_{I} und der Streckenimpedanz Z_{P} in Serie und bei durchgeschalteter Schaltstrecke S₁, wie aus Fig. 12c ersichtlich, über den durchgeschalteten Entladestromzweig kurzgeschlossen ist.

Die Funktionsweise dieser Anlagekonfiguration ist die folgende:

In Ionenplattierungsphasen, d.h. Betriebsphasen, während welchen die Schicht auf den Werkstücken 1 aufgebaut wird, ist die Schaltstrecke S₁ geöffnet. Während dieser Phasen wird mit der Quelle 46a, beispielsweise wie in den Fig. 12b und 12c dargestellt, als Stromimpulsquelle ausgebildet, eine Ladung, beispielsweise in Form eines Stromstosses, durch die Serieschaltung gemäss Fig. 12b getrieben. Die Polarität der aufgezwungenen Ladung (Stromintegral) wird wie eingezeichnet gewählt. Damit lädt sich die diskrete Kapazität C_{D1} und ebenso der Streckenkondensator C_{I} auf, wobei das sich in der Vakuumatmosphärenstrecke aufbauende Feld E in der in Fig. 12b eingetragenen Richtung als die positiven Ionen hin zu den Werkstücken 1 treibendes Feld aufbaut: Es baut sich an der Isolationsbelegung am Werkstück, d.h. dessen nicht oder schlecht leitende Oberfläche, eine Ladungsbelegung auf, welche dem während dieser Plattierungsphase geflossenen Strom i entspricht.

Daraus ist ersichtlich, dass die Menge mittels der Quelle 46a aufgezwungener Ladung mindestens genähert der in der Plattierungsphase auf die Werkstücke 1 aufgebrachten Ladungsbelegung entspricht. Durch Aenderung der extern aufgezwungenen Ladung in den Plattierungsphasen wird mithin diese Ladungsbelegung und damit die Schichtaufbaurate geändert.

Nach bzw. zwischen diesen Plattierungsphasen wird die Schaltstrecke S₁ in der bis anhin beschriebenen Art und Weise geschlossen.

Wie bereits aucn die vorgängig beschriebenen, im Entladestromkreis vorgesehenen diskreten Kapazitäten, wirkt auch C_{D1} kurzzeitig, in bekannter Art und Weise, als Kurzschluss. Bei Schliessen der Schaltstrecke S₁ entsteht die in Fig. 12c ersichtliche Konfiguration, die an sich parallel geschalteten Elemente, nämlich der Kondensator C_{I} und die Kapazität C_{D1}, sind gleichgerichtet aufgeladen, wie eingetragen, womit nun der Entladevorgang der diskreten Kapazität C_{D1} den Ent- bzw. Umladevorgang des Kondensators C_{I} beschleunigt. Die Zeitkonstante des Entladevorganges wird durch die Serieschaltung der beiden kapazitiven Elemente gegeben, so dass, durch Wahl des Kapazitätswertes der Kapazität C_{D1} wesentlich grösser als der Kapazitätswert des Kondensators C_{I}, das Zeitverhalten des Entladevorganges durch C_{I} und die Impedanz Z_{P} im wesentlichen bestimmt bleibt.

Die auf C_{D1} aufgebrachte Anfangsladung ist im wesentlichen gleich wie die auf C_{I} aufgebrachte (Serieschaltung), so dass der Entladevorgang beschleunigt wird, durch den die Spannungen im Parallelkreis auf gleiche Werte gebracht werden.

Es ist ohne weiteres ersichtlich, dass nach Abklingen des Entladevorganges die Spannungen an C_{D1} und C_{I} gegengleich gerichtet sind (Parallelschaltung).

Da, wie oben erläutert wurde, während des Entladevorganges im wesentlichen nur die Ladungsbelegung der Ionen neutralisiert wird und nicht die Materialbelegung mit Ionenpartikeln geändert wird, erfolgt im Entladezyklus im wesentlichen keine Aenderung an der bereits aufgebauten Schicht.

In Fig. 12a ist bereits auch eine Weiterbildung dieser bevorzugten Verfahrensvariante, insbesondere für Ionenplattieren, dargestellt. Hiernach wird wiederum, wie bereits beschrieben wurde, der Entladestrom gemessen, gegebenenfalls analog/digital am Wandler 34 gewandelt und als IST-Verlauf in der Speichereinrichtung 30 abgespeichert. Der Speicherinhalt an der Speichereinheit 30, als Zwischenspeicher wirkend, wird an der Vergleichseinheit 38 mit dem im SOLL-Wert-Speicher 40 vorab gespeicherten Entlade-SOLL-Verlauf, bzw. einer charakteristischen Grösse desselben, verglichen.

An der Auswerteeinheit 42 werden die charakteristischen IST/SOLL-Verhaltensdifferenzen Δ ermittelt, gegebenenfalls unter Berücksichtigung der sich mit ändernder Zeitkonstanten ändernden C_{I}-Werte. Mit dem Auswerteresultat wird, in regelndem Sinne, so auf die Quelle 46a eingewirkt, dass das gemessene IST-Entladeverhalten bzw. dessen charakteristische Kenngrösse demjenigen des SOLL-Entladeverhaltens entspricht. Auf diese Art und Weise ist es möglich, durch Beeinflussung der Ladungsbelegung der Werkstücke 1 während der Plattierphasen den Schichtaufbau zu beherrschen und dabei die betreffs Ueberschläge gefährlich werdende Ladungsbelegung zu neutralisieren.

In Fig. 13 ist eine Weiterausbildung bzw. eine einfache Realisationsform der anhand von Fig. 12 beschriebenen Technik dargestellt, woraus ersichtlich ist, dass nun die Erfindung unter ihrem in Fig. 4 beschriebenen, kombinierten Aspekt verwirklicht ist. Die Verhältnisse im Vakuumrezipienten 3 sind wie in Fig. 12 dargestellt und beschrieben. Es geht im wesentlichen darum, auf höchst einfache Art und Weise die Quelle 46a zu realisieren. Hierzu wird vom Gleichstromgenerator 8 gemäss Fig. 4 über eine Drossel L₆₆ auf das anhand von Fig. 12a erläuterte Netzwerk anstelle der Quelle 46a eingewirkt.

Der Gleichstromsignalgenerator 8 ist, wie bei U_{B} eingetragen, beispielsweise gepolt. Bei geschlossener Schaltstrecke S₁ fliesst, vorerst ohne Berücksichtigung der Einheit 56, ein Strom durch die Drossel L₆₆ über die geschlossene Schaltstrecke S₁. Der dann fliessende Strom ist in Fig. 13 mit I₁ eingetragen.

Wird nun die Schaltstrecke S₁ zur Einleitung einer Plattierungsphase geöffnet, so entsteht über der Drossel L₆₆ ein hoher negativer Spannungsimpuls, wie schematisch bei U_{L66} eingetragen, welcher durch den nun seriegeschalteten Kreis gemäss Fig. 12b die anhand von Fig. 12 erläuterte Ladung durch C_{D1} und C_{I} treibt. Nach Ausklingen des transienten Vorganges liegt an C_{I} und C_{D1} gemeinsam die Spannung U_{B} an. Durch Vorsehen der Drossel L₆₆ wird in dieser Plattierungsphase der transiente Vorgang beschleunigt. Die Wirkungsweise bleibt im wesentlichen dieselbe, wenn die Drossel L₆₆ weggelassen wird und bei Oeffnen der Schaltstrecke S₁ direkt U_{B} auf die Serieschaltung der beiden kapazitiven Elemente C_{I} und C_{D1} geschaltet wird.

Allerdings muss dabei sichergestellt sein, dass der gleiche Gleichstromsignalgenerator 8 ausgangsseitig in der Lage ist, die Spannung zu halten und dabei die kapazitive Last rasch aufzuladen.

Bei Vorsehen der Drossel L₆₆ kann in den Entladestromkreis beispielsweise auch ein elektronisch variierbarer Widerstand, wie eine Transistorstufe 56, geschaltet werden, welche ausgangsseitig der Auswerteeinheit 42 gemäss Fig. 12a verstellt wird und damit der durch die Drossel L₆₆ bei geschlossener Schaltstrecke S₁ fliessende Strom. Durch Veränderung dieses Stromes wird die Spannungsspitze U_{L66} verändert und damit das Zeitverhalten in der transienten Plattierungsphase. Durch Aenderung des Widerstandswertes an der Einheit 56 zwischen Plattierungsphasen und Entladungsphasen kann die Einheit 56 in den Entladungsphasen unwirksam gemacht werden (Kurzschluss) oder auch dort zur Beeinflussung des transienten Zeitverhaltens gestellt werden. Dabei kann im weiteren die Schaltstrecke S₁ mit der Einheit 56, beispielsweise als Transistorsteuereinheit, kombiniert werden.

Selbstverständlich ist es ohne weiteres möglich, den Widerstandswert an der Einheit 56 ohne Vorsehen einer Entladestrommessung mit entsprechender Rückführung, wie sie in Fig. 12a erläutert wurde, vorzunehmen und die Einheit 56, z.B. nach Vorversuchen eingestellt, direkt synchronisiert mit dem Taktgeber 16, 160 von Fig. 12 zu betreiben.

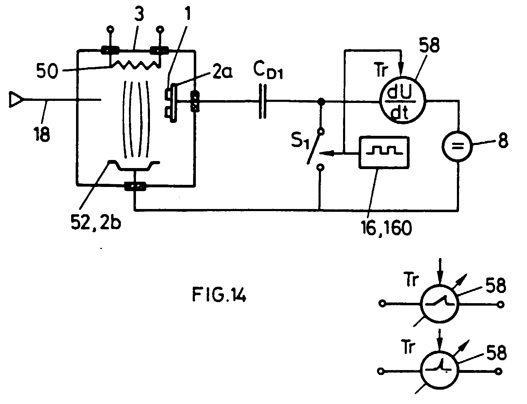

Alternativ zur Ausbildung gemäss Fig. 13 kann in einer weiteren bevorzugten Variante, wie in Fig. 14 dargestellt, vorgegangen werden, wodurch ein äusserst effizienter und beherrschter Ladungstransfer in Plattierungsphasen, d.h. eine höchst effiziente Steuerung der Ladungsbelegung in diesen Phasen erfolgt. Hierzu wird an der Anordnung gemäss Fig. 12a dem Ausgangssignal des Gleichstromsignalgenerators 8 ein Spannungssignal, wie mit der Quelle 58 dargestellt, überlagert, dessen Spannung sich in vorgegebener Art und Weise in der Zeit verändert, d.h. mit vorgegebenem Verlauf dU/dt.

Diese Quelle 58 wird mit dem Ausgangssignal des Taktgebers 16 bzw. 160 an einem Triggereingang Tr getriggert, und zwar jeweils in den Plattierungsphasen, d.h. bei geöffneter Schaltstrecke S₁. Wie in Fig. 14 unten dargestellt, kann die Quelle 58, je nach erwünschtem Schichtwachstumsverlauf an den zu beschichtenden Werkstücken 1, getriggert, eine lineare oder eine progressive Rampe oder eine andere Kurvenform ausgeben mit gegebenem Verlauf ihrer zeitlichen Ableitung. Aufgrund des differenzierenden Verhaltens der Serieschaltung der beiden kapazitiven Elemente C_{I} und C_{D1} ergibt sich in bekannter Art und Weise der Stromfluss und damit der Ladungsfluss pro Zeiteinheit aus der zeitlichen Ableitung der erwähnten Spannungsverläufe. Diese Ableitung kann im Sinne der Erläuterungen zu Fig. 10, Quelle 44, auch als Stellgrösse in einem Regelkreis eingesetzt werden.

Wie bereits auch anhand von Fig. 13 diskutiert wurde, kann mithin ein erwünschter Verlauf der zeitlichen Ableitung voreingestellt werden oder kann, im Rahmen einer Regelung, wie über die Auswerteeinheit 42, so gestellt werden, dass in den Plattierungsphasen eine erwünschte Ladungsbelegung erfolgt, was, wie erwähnt, z.B. aus dem Entladeverhalten regelungstechnisch überprüft werden kann.

Das Fahren eines Plattierungsstrom-Stell- oder -Steuersignals ist auch in Fig. 13 gestrichelt dargestellt, bei welchem, anstatt eine zusätzlich getriggerte Spannungsquelle vorzusehen, die Ausgangsspannung des Gleichstromsignalgenerators 8 im Synchronismus mit dem Ausgangssignal des Taktgenerators 16 bzw. 160 in der Zeit variiert wird.

Das anhand der Fig. 11, 12, 13 und 14 dargestellte Verfahren lässt sich insbesondere mit einem Ionenplattierverfahren höchst vorteilhaft kombinieren, womit sich, wie erwähnt wurde, ein neuartiges Ionenplattierverfahren ergibt mit der Möglichkeit, leitende Schichten auf nicht leitenden Oberflächen abzulegen, nicht leitende Schichten auf leitenden Oberflächen oder auf nicht leitenden.

Das Verfahren, wie es für die Steuerung der Ladungsbelegung anhand der Fig. 12 bis 14 während der Plattierungsphasen beschrieben wurde, wird an sich als Erfindung betrachtet, welche sich selbstverständlich in höchst geeigneter Art und Weise mit der vorliegenden Erfindung wie beschrieben kombinieren lässt.

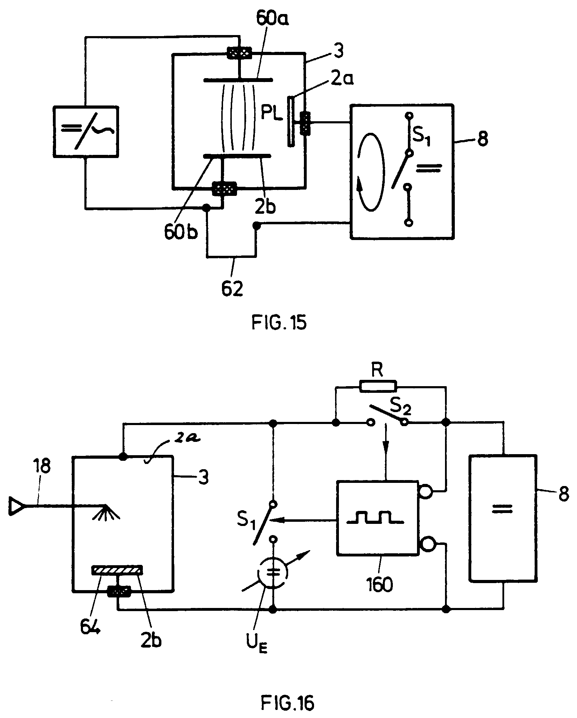

Bei allen Ausführungsvarianten des erfindungsgemässen Verfahrens, bei welchen gemäss Fig. 4 ab einem Gleichstromsignalgenerator 8 über Zerhackereinheit 14_{S} oder, wie beschrieben wurde, über einen Zerhakkerschalter S₁, erfindungsgemäss auf eine Strecke zwischen zwei leitenden Flächen 2a, 2b in einem Vakuumrezipienten 3 eingewirkt wird und in der Vakuumatmosphäre eine Plasmaentladung PL, wie in Fig. 15 schematisch dargestellt, unterhalten wird, zwischen Elektroden 60a und 60b, wird einer elektrischen Instabilität dadurch wirksam begegnet, dass, wie dargestellt, eine der plasmaentladungsstromführenden Elektroden, z.B. 60b, auf ein Potential an der Entladestromschleife gelegt wird. Bevorzugterweise wird hierzu als eine der erfindungsgemäss eingesetzten leitenden Flächen gemäss Fig. 15, beispielsweise Fläche 2b, eine der Plasmaelektroden eingesetzt.

Dies ist durch die Verbindung 62 in Fig. 15 dargestellt.

In Fig. 16 ist schematisch ein weiteres bevorzugtes Ausführungsbeispiel des erfindungsgemässen Vorgehens bzw. einer erfindungsgemässen Anlage dargestellt. Im Vakuumrezipienten 3 wird, beispielsweise zwischen Rezipientenwandung und einem Target 64 aus leitendem oder zumindest halbleitendem Material, eine Glimmentladung betrieben. Ueber eine Gaszuführung 18 wird ein Arbeitsgas mit Reaktivgasanteil eingelassen. Es handelt sich mithin um einen reaktiven Kathodenzerstäubungsprozess. Das Target 64 kann Teil einer Magnetronzerstäubungsquelle sein. Die Werkstücke sind in Fig. 16 nicht eingetragen. Sie werden entweder potentialschwebend betrieben oder auf ein Bias-Potential gelegt, beispielsweise auch, wie insbesondere für das Ionenplattieren, anhand der Fig. 11 bis 14 dargestellt wurde.

Die Glimmentladung, am dargestellten Beispiel zwischen Rezipient und Target 64 betrieben, wird erfindungsgemäss, prinzipiell, nach dem Vorgehen von Fig. 4 betrieben. Nach den bereits gemachten Erläuterungen bedarf Fig. 16 nicht mehr wesentlicher Ausführungen. Da der Gleichstromsignalgenerator 8 für den Betrieb der Glimmentladung relativ hohe Leistungen abgeben muss, wird dann, wenn die Schaltstrecke S₁ durch den Taktgeber 160 geschlossen wird, also gegentaktig, eine Serieschaltstrecke S₂ geöffnet, damit nicht der Glimmentladungsstrom über die Schaltstrecke S₁ fliesst. Insbesondere, wenn der Gleichstromsignalgenerator 8 die Charakteristik einer Gleichstromquelle aufweist, wird die Schaltstrecke S₂ bevorzugterweise durch ein Netzwerk überbrückt, bevorzugterweise durch ein Widerstandsnetzwerk, wie mit R in Fig. 16 dargestellt, gegebenenfalls aber auch mittels eines elektronisch steuerbaren Netzwerkes, wie einem Transistornetzwerk.

Damit wird erreicht, dass sich bei geöffneter Schaltstrecke S₂ darüber nicht eine zu hohe Spannung aufbaut.

Die vorbeschriebenen Massnahmen, wie Vorsehen einer gegebenenfalls gesteuerten, den Entladevorgang beeinflussenden Spannungsquelle U_{E} gemäss Fig. 7c bzw. Massnahmen zur Messung des Entladevorganges und entsprechendem Eingriff auf den Taktgeber 160, wie dies anhand von Fig. 8 beschrieben wurde, werden auch hier bevorzugterweise eingesetzt. Vor allem Vorgehen nach Fig. 8 ermöglicht im Falle des Kathodenzerstäubens, z.B. nach Fig. 16, den Anlagenwirkungsgrad dadurch zu optimieren, dass die Entladephasen adaptiv optimal kurz gehalten werden.

Bei dem erfindungsgemässen Ionenplattieren gemäss den Fig. 11 bis 14 wird bevorzugterweise das Signal des Gleichstromsignalgenerators 8 mit einer Häufigkeit von 50kHz bis 500kHz geändert, bevorzugterweise von mindestens 90kHz, insbesondere bevorzugterweise mit mindestens 100kHz, was dem Betrieb der Schaltstrecke S₁ mit den angegebenen Frequenzen gleichkommt, also dem Betrieb des Taktgenerators 16, 160 mit den angegebenen Repetitionsfrequenzen. Die Schliesszeiten der Schaltstrecke S₁ werden dabei bevorzugterweise zu 50nsec bis 10µsec, vorzugsweise von 0,5µsec bis 2µsec oder von 2µsec bis 10µsec gewählt, auch in Abhängigkeit der gewählten Repetitionsfrequenz und des durchzuführenden Behandlungsverfahrens, insbesondere Ionenplattierverfahrens.

Beim Sputtern, wie es anhand von Fig. 16 als ein bevorzugtes Ausführungsbeispiel beschrieben wurde, werden bevorzugterweise Betriebsfrequenzen der Schaltstrecke S₁ entsprechend der Häufigkeit, mit welcher das Ausgangssignal des Gleichstromsignalgenerators 8 geändert wird, mit Frequenzen entsprechend 50Hz bis 1MHz betrieben, vorzugsweise mit 5kHz bis 100kHz, dabei besonders vorteilhafterweise mit Frequenzen zwischen 10kHz und 20kHz. Auch hier werden als Schliesszeit bzw. Entladezeit durch die Schaltstrecke S₁ Längen von 50nsec bis 10µsec, vorzugsweise von 0,5µsec bis 2µsec oder von 2µsec bis 10µsec gewählt, abgestimmt auf das beabsichtigte Behandlungsverfahren bzw. die eingestellte Repetitionsfrequenz.

Das anhand von Fig. 16 beschriebene erfindungsgemässe Verfahren eignet sich insbesondere für die Bildung von Siliciumoxidschichten, d.h. von SiₓO_{y}. Das Verfahren eignet sich auch ausgezeichnet, um mit einer Zerstäubungskathode aus einer Mischung aus Indiumoxid und Zinnoxid oder Indium und Zinn eingesetzt zu werden, welches Material in einer Atmosphäre, die Sauerstoff enthält, zerstäubt wird, um eine entsprechende Beschichtung an Werkstücken zu erzeugen. Selbstverständlich kann dieselbe Vorrichtung auch verwendet werden, um anstelle eines Targets die Oberfläche von Werkstücken oder aber auch eines Targets zu ätzen mit dem Ziel, eine Verschmutzungsschicht, wie eine Oxidschicht, oder andere unerwünschte Oberflächenschichten zu entfernen.

Der reaktive Kathodenzerstäubungsprozess, wie er anhand von Fig. 16 beschrieben wurde, kann im oxidischen (reaktiven) oder im Uebergangsmode betrieben werden, wobei bezüglich Definition dieser Betriebsmode auf "Reaktives DC-Hochratezerstäuben als Produktionsverfahren" von S. Schiller et al.; Vortrag zur International Conference on metal coating, San Diego/ Cal., March 1987, Surface and Coating Technology 33 (1987), verwiesen wird.

Es wurde dabei beobachtet, dass beim erfindungsgemässen Kathodenzerstäubungsverfahren der Uebergang vom metallischen in den Reaktivmode weit weniger abrupt, als dies üblich ist, erfolgt. Dies besagt, dass beim erfindungsgemässen Verfahren die Kennlinie des an sich instabilen Zwischenbereiches, dem Intramode, flacher als üblich verläuft und mithin ein Prozessarbeitspunkt in diesem Uebergangsbereich einfacher als üblich regeltechnisch stabilisiert werden kann.

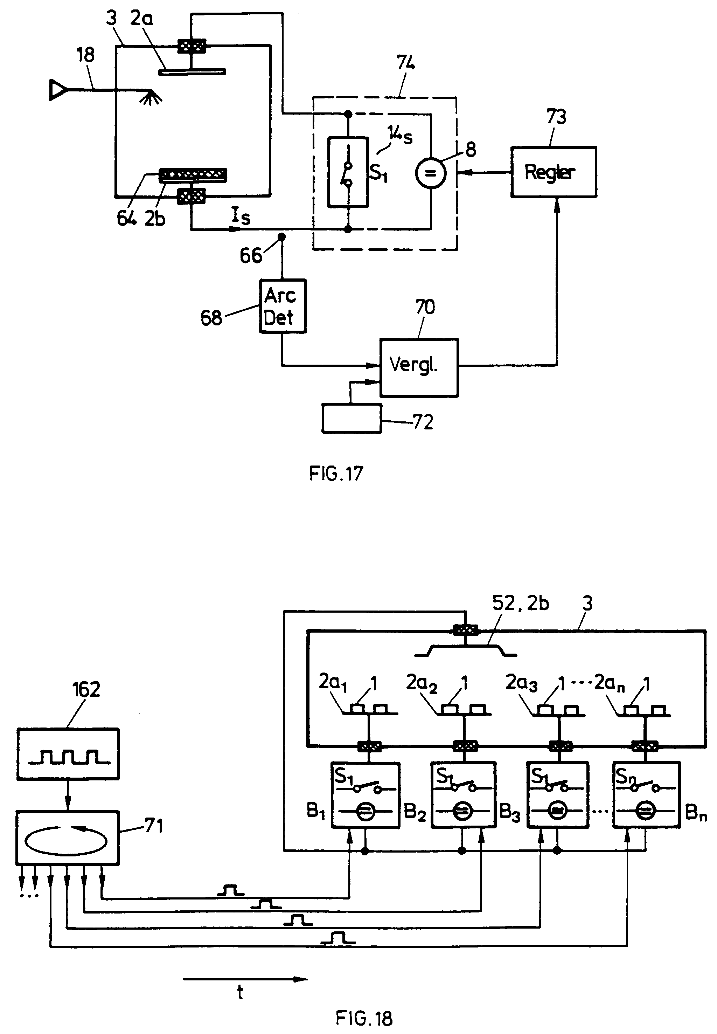

In Fig. 17 ist eine weitere, vor allem im Zusammenhang mit dem Kathodenzerstäuben gemäss Fig. 16, bevorzugte Ausführungsvariante dargestellt. Allerdings kann dieses Vorgehen auch im Zusammenhang mit Ionenplattieren oder anderen erfindungsgemässen Verfahren, wovon einige Beispiele noch anhand von Fig. 19 erläutert werden sollen, eingesetzt werden. Ohne beschränkend sein zu wollen, wird aber Fig. 17 auf der Basis des Kathodenzerstäubungsverfahrens gemäss Fig. 16 dargestellt.

Anstatt den Entladestrom zu messen, wird hier, beispielsweise in dem die Glimmentladung speisenden Strom, wie dargestellt, mit einem Stromdetektor 66 oder gegebenenfalls auch im Vakuumrezipienten optisch, das Entstehen von stochastischen Störentladeerscheinungen registriert, welche sich in Stromspitzen im Entladestrom I_{S} bemerkbar machen. Von einer Strommesseinrichtung 66 wird das Verhalten des gemessenen Stromes an einer Arc-Detektionseinheit 68 daraufhin geprüft, ob die erwähnten stochastischen Entladeerscheinungen auftreten. Das Ausgangssignal der Arc-Detektionseinheit 68 wird einer Vergleichseinheit 70 zugeführt. Darin wird registriert, mit welcher Häufigkeit die erwähnten Entladeerscheinungen auftreten und/oder mit welcher Intensität. Die ermittelte Kenngrösse wird an der Vergleichseinheit 70 mit einer von einer Vorgabeeinheit 72 entsprechend vorgegebenen SOLL-Kenngrösse verglichen, und, entsprechend dem Vergleichsresultat, wird vom Ausgang der Vergleichseinheit 70 über einen Regler 73 auf die erfindungsgemässe Anordnung, gestrichelt im Block 74 dargestellt, eingegriffen.

Mit dem Regler 73 kann dabei auf die Repetitionsfrequenz und/oder die Länge, mit welcher die Schaltstrecke S₁ geschlossen wird, über den Taktgenerator 16 bzw. 160 eingewirkt werden, dies auch bei einer elektrisch nicht aktiv gespiesenen Strecke zwischen den leitenden Flächen 2a und 2b, oder, wie hier beim Kathodenzerstäuben, wenn erfindungsgemäss der Gleichstromsignalgenerator 8 zum Betrieb der erwähnten Strecke vorgesehen ist.

Wenn beispielsweise die registrierte Frequenz auftretender Entladeerscheinungen zu hoch ist, so wird die Wiederholfrequenz des Schliessens der Schaltstrecke S₁ erhöht und/oder die Zeitabschnitte, während welchen S₁ den Entladestromkreis schliesst. Auch damit wird ein optimaler Wirkungsgrad erreicht, indem Entladezyklen nur so oft und so lange ausgelöst werden, wie das IST-arcing-Verhalten dies aufzwingt.

Insbesondere wird dadurch die notwendige Wiederholfrequenz der Ent- bzw. Umladezyklen dem Wachstum einer Isolationsbelegung nachgeführt. Dies bei ständiger Optimierung des Anlagenwirkungsgrades.

Messeinrichtungen zur Erfassung der erwähnten Entladeerscheinungen im Glimmentladungsstrom sind bekannt.

Bevorzugterweise wird dieses Vorgehen an einer Kathodenzerstäubungsanlage, wie sie in Fig. 16 dargestellt wurde, eingesetzt.

In Fig. 18 ist eine weitere wesentliche Ausbildungsvariante des erfindungsgemässen Vorgehens dargestellt, welche insbesondere beim Ionenplattieren gemäss den Fig. 11 bis 14 wesentlich ist. Trotzdem ist auch dieses Vorgehen nicht auf Ionenplattieren beschränkt. Fig. 18 zeigt jedoch, ohne beschränkend wirken zu wollen, die Weiterausbildung des Ionenplattierens, wie es anhand der Fig. 11 bis 14 dargestellt wurde.

In Fig. 18 sind für Teile, die bereits in Fig. 12 beschrieben wurden, dieselben Bezugszeichen eingesetzt. Im Vakuumrezipienten 3 wird in einer der vorbeschriebenen Arten Ionenplattieren vorgenommen, beispielsweise mit einem Verdampfungstiegel 52, welcher die eine der leitenden Flächen 2b bildet. Die Glimmentladungsstrecke oder eine andere Plasmaentladungsstrecke gemäss den Ausführungen zu Fig. 12 ist hier nicht mehr eingezeichnet. Es sind nun aber mehrere Werkstückträgerflächen 2a₁, 2a₂, 2a₃, ..., 2aₙ vorgesehen, worauf ionenzuplattierende Werkstücke 1 abgelegt sind. Die jeweiligen Paare erfindungsgemäss betriebener leitender Flächen 2aₓ und 2b sind je, wie hier nur noch schematisch dargestellt, durch einen erfindungsgemässen Betriebsblock Bₓ betrieben, je ausgebildet, wie anhand der Fig. 11 bis 14 dargestellt wurde.

Werden bei einer solchen Konfiguration alle vorgesehenen Schaltstrecken S₁, wie schematisch eingetragen, gleichzeitig durchgeschaltet, so wird dem Prozess und insbesondere, bei seinem Plasmabetrieb der Plasmaentladung, massgebend Energie entzogen. Dies führt zu Instabilitäten der Prozessführung.

Deshalb wird gemäss Fig. 18 ein Taktgenerator 162 vorgesehen und über eine Zeitstaffelungseinheit 71, wie z.B. über eine Schieberegistereinrichtung, jede der vorgesehenen Einheiten B₁ bis Bₙ zeitgestaffelt zyklisch angesteuert. Dies ist schematisch über der Zeitachse t mit den gestaffelten Steuerimpulsen dargestellt. Wenn erwünscht ist, jede der vorgesehenen Strecken 2aₓ/2b separat optimiert betreiben zu können, so werden, zu jeder Strecke separat, Taktgebereinheiten 16 bzw. 160 gemäss Fig. 12 vorgesehen, und jede der Strecken wird gemäss den Fig. 11 bis 14 betrieben, wobei aber eine Synchronisationseinheit sicherstellt, dass über die Taktgeber 16 bzw. 160, wie in Fig. 18 dargestellt, die Strecken in der Zeit gestaffelt insbesondere entladen werden. Selbstverständlich können gegebenenfalls mehrere Werkstückträgerflächen 2aₓ zu Gruppen zusammengefasst werden, die zwischen sich zeitgestaffelt betrieben werden.

Im weiteren muss betont werden, dass mit der in Fig. 6 und nachfolgenden Figuren dargestellten und beschriebenen Zerhackereinheit 14 bzw. 14ₛ viele bestehende Vakuumbehandlungsanlagen mit Gleichstromsignalgeneratorspeisung um- bzw. nachgerüstet werden können, so dass mit solchen Anlagen dann Behandlungsprozesse gefahren werden können, für welche bis anhin andere Anlagen, insbesondere mit anderen Generatoren gemäss den Fig. 1, eingesetzt werden mussten. Somit können mit ein und denselben Anlagen dann Verfahren gefahren werden, welche einerseits mit Gleichstromspeisung betrieben werden können, aber auch solche, die bis anhin nicht mit Gleichstromsignalgeneratorspeisung betrieben werden konnten, nun aber mit dem Einsatz der vorliegenden Erfindung auch für derartige Verfahren eingesetzt werden können.

In Fig. 19 sollen einige Einsatzmöglichkeiten der vorliegenden Erfindung dargestellt werden, um, ohne Anspruch auf Vollständigkeit und ohne beschränkend wirken zu wollen, den Bereich abstecken zu können, welche Verfahren erfindungsgemäss betrieben werden können. Es wird daraufhin für den Fachmann ohne weiteres möglich, auch im Zusammenhang mit der vorangehenden Beschreibung, weitere erfindungsgemässe Behandlungsverfahren bzw. Anlagen vorzuschlagen.

Gemäss Fig. 19 wird von einem Werkstück 1 aus schlecht oder nicht leitendem Material, somit selbst eine Isolationsbelegung bildend, ausgegangen. Im Vakuumrezipienten 3 wird auf eine der bekannten Arten eine Plasmaentladung PL erzeugt. Das Werkstück 1 kann einer Aetzbehandlung unterworfen sein, kann mit einer leitenden oder ebenfalls nicht leitenden Beschichtung versehen werden, sei dies durch Verdampfen leitender oder nicht leitender Ausgangsmaterialien, reaktiv oder nicht reaktiv, Zerstäuben leitender oder halbleitender Materialien, wiederum reaktiv oder nicht reaktiv. Die erfindungsgemässe Betriebseinheit, wie vorgängig beschrieben, ist schematisch mit dem Block 5 dargestellt.

In Fig. 19a ist, ausgehend von der Darstellung von Fig. 19, eine Plasmaentladung dargestellt zwischen Plasmaentladungselektroden 80a und 80b, welche Plasmaentladung durch einen eigens dafür vorgesehenen Gleich- oder Wechselstromgenerator 82 unterhalten wird. Bei diesem Vorgehen handelt es sich beispielsweise um ein Ionenplattierverfahren. Die erfindungsgemäss betriebenen leitenden Flächen 2a und 2b werden unabhängig von der Plasmaentladung betrieben. Soll beispielsweise nicht oder schlecht leitendes Material zerstäubt werden, um nachmals in einem reaktiven oder nicht reaktiven Prozess auf die Werkstücke 1 abgelegt zu werden, so ist ersichtlich, dass der Generator 82 bevorzugterweise als Hochfrequenzgenerator in bekannter Art und Weise ausgebildet wird (vgl. auch Fig. 19f).

Gemäss Fig. 19b wird die Plasmaentladung PL durch das Feld einer Induktionsspule 84 unterhalten. Bezüglich Beschaltung der erfindungsgemäss betriebenen leitenden Flächen 2a und 2b ändert sich bezüglich Fig. 19a nichts. Gemäss Fig. 19c wird wiederum eine Plasmaentladung zwischen Plasmaentladungselektroden 80a und 80b erzeugt, wobei hier eine der Plasmaentladungselektroden, beispielsweise 80b, als eine der erfindungsgemäss betriebenen leitenden Flächen, beispielsweise 2a, eingesetzt ist.

Gemäss Fig. 19d wird ein Werkstück 1 in einer Plasmaentladungsstrecke beispielsweise geätzt, wobei hier die Elektroden 80a bzw. 80b gleichzeitig die erfindungsgemäss betriebenen leitenden Flächen 2a und 2b bilden.

Mit der Plasmaentladung gemäss den Fig. 19a, 19c kann ein Material auf einer der Plasmaentladungselektroden zerstäubt werden, um als solches auf einem Werkstück 1 abgelegt zu werden oder nach Reaktion mit einem in den Vakuumrezipienten 3 eingelassenen Arbeitsgas bzw. Teilen eines solchen Gases. Desgleichen kann mit der dargestellten Plasmaentladung verdampftes Material ionisiert werden, um im Sinne der Ionenplattierung auf Werkstücke abgelegt zu werden, sei dies als solches oder wiederum nach Reaktion mit dem Vakuumrezipienten 3 zugeführtem Reaktivgas. Grundsätzlich ist die Art und Weise, wie die Materialquellen oder die Ionisierung im Vakuumrezipienten realisiert wird, für die vorliegende Erfindung von untergeordneter Bedeutung, wesentlich ist, dass erfindungsgemäss isolationsbelegte Werkstücke in mit Ladungsträgern versehener Vakuumatmosphäre behandelt werden sollen.

Es kann Bogenverdampfen, eine sog. rod-feed-Technik, Elektronenstrahlverdampfen, thermisches Verdampfen, Sputtern eingesetzt werden, alles reaktiv oder nicht reaktiv, weiter auch plasmaunterstütztes CVD, PECVD, eingesetzt werden.

Gemäss Fig. 19e wird im Vakuumrezipienten 3 ein Zielobjekt (Target) 85 aus leitendem oder zumindest halbleitendem Material in der Plasmaentladung zerstäubt und das abgestäubte Material als solches oder nach Reaktion mit einem Reaktivgas im Rezipienten 3 als leitende oder als nicht bzw. schlecht leitende Schicht auf dem Werkstück 1 abgelegt. In ersterwähntem Fall weist das Werkstück eine nicht oder schlecht leitende Oberfläche auf, die durch vorgängige Beschichtung erzeugt sein kann oder dem Werkstückmaterial inhärent ist.

Hier können gegebenenfalls beide Strecken, nämlich die Plasmaentladungsstrecke zwischen den leitenden Flächen 2a und 2b₁ sowie zwischen 2a und 2b₂ erfindungsgemäss betrieben werden. Generell werden vorteilhafterweise immer solche Strecken erfindungsgemäss betrieben, an deren Elektroden bzw. leitenden Flächen Ablagerungen nicht oder schlecht leitender Materialien zu befürchten sind bzw. daran derartige Materialien vorgesehen sind.

Gemäss Fig. 19f wird in einer Hochfrequenzplasmaentladung nicht oder schlecht leitendes Material eines Zielobjektes 87 kathodenzerstäubt und wird gegebenenfalls zusätzlich mit einem durch die Leitung 18 eingelassenen Reaktivgas zur Reaktion gebracht. Auf Werkstücken 1 wird im Sinne des Ionenplattierens eine Schicht nicht oder schlecht leitenden Materials abgelegt, wozu in diesem Fall die Werkstückträgerelektrode durch eine der erfindungsgemäss betriebenen leitenden Flächen 2b gebildet wird und eine zweite, von der Plasmaentladungsstrecke abgetrennte, weitere leitende Fläche 2a vorgesehen ist.

Gemäss Fig. 19g wird zwischen zwei Plasmaentladungselektroden 80a und 80b z.B. eine Glimmentladung unterhalten und von einem Tiegel Material verdampft, leitendes, nicht oder schlecht leitendes. In der Plasmaentladung wird das verdampfte Material ionisiert und, im Sinne des Ionenplattierens, auf Werkstücke 1 eine leitende oder nicht bzw. schlecht leitende Schicht abgelegt. Auch hier kann es sich um einen Reaktivprozess handeln, bei welchem durch die Gaszuführung 18 ein Reaktivgas dem Prozess zugeführt wird.

Sowohl die Glimmentladung GL wie auch die Strecke zwischen den beiden leitenden Flächen 2a und 2b werden erfindungsgemäss wie wiederum mit den Blöcken 5 dargestellt betrieben.

Schliesslich zeigt Fig. 19h eine Ausführungsvariante der Erfindung, analog zu Fig. 19g, wobei aber hier die Plasmaentladung zur Ionisation des verdampften Materials durch das Magnetfeld einer Wicklung 91 im Rezipienten 3 erzeugt wird.

Die aufgeführten Beispiele mögen dem Fachmann aufzeigen, in welchem Umfange die vorliegende Erfindung einsetzbar ist.

### Beispiele zum erfindungsgemässen Kathodenzerstäuben:

| | | |
|---|---|---|
| 1) Anlage | BAS 450 der Firma Balzers AG | |
| Kathode | AK 510 der Firma Balzers AG | |
| Magnetsystem | MA 525 der Firma Balzers AG | |
| | | |
| Target | S10-2403 | Silicium-Target |
| | | (12,7 x 25,4cm) |
| DC Powersupply | | 10kW |
| Target-Substratabstand | | 70mm |
| Drehkorbdrehfrequenz | | < 0,5Hz |
| Entladefrequenz | | 17kHz |
| Entladezeit | | 9µsec |
| Entladespannung | | Kurzschluss |
| Effektive Sputterleistung | | 2kW |
| Anlagendrücke | Ar: | pAr=8E-3mbar |
| | O₂: | pO2=2E-3mbar |
| DC-Spannung am Target | | |
| im Metallmode | | -668V |
| im Arbeitspunkt, zwischen Metallmode und Oxidmode | | -340V |
| Schicht | | SiO2 |
| Brechwert SiO2, bei λ = 633nm | | 1,47 |
| k-Wert SiO2, bei λ = 633nm | | <1E-5 |

| | | |
|---|---|---|
| 2) Anlage | BAK 760 der Firma Balzers AG | |
| Kathode | AK 525 der Firma Balzers AG | |
| Magnetsystem | MA 525 der Firma Balzers AG | |
| | | |
| Target | S10-3976 | Silicium-Target |
| | | (12,7 x 63,5cm) |
| DC Powersupply | | 10kW |
| Target-Substratabstand | | 60mm |
| Drehkorbdrehfrequenz | | 0,5Hz |
| Entladefrequenz | | 17kHz |
| Entladezeit | | 16µsec |
| Entladespannung | | Kurzschluss |
| Effektive Sputterleistung | | 2kW |
| Prozessdrücke | Ar: | pAr=8E-4bar |
| | O₂: | pO2=2E-5mbar |
| DC-Spannung am Target | | |
| im Metallmode | | -660V |
| im Arbeitspunkt, zwischen Metall- und Oxidmode | | -550V |
| Schicht | | 284nm SiO2 |
| Energieausbeute | | DDR(SiO2)= 44,6nm mm^2/Ws |
| (DDR = hergestelltes Schichtvolumen pro aufgewandte Energie) | | |
| Brechwert SiO2 | | |
| bei λ = 633nm | | 1,47 |
| k-Wert SiO2 | | |
| bei λ = 633nm | | <1E-5 |

### Beispiele zum erfindungsgemässen Ionenplattieren

1. Formwerkzeuge wurden mittels einer Anlage, aufgebaut wie schematisch in Fig. 12a dargestellt, in der Ausführungsvariante nach Fig. 15 und 18, in einem reaktiven Ionenplattierverfahren, unter Verdampfen von Silicium, mit einer Siliciumnitridschicht versehen. Die dadurch korrosionsfest beschichteten Formwerkzeuge wurden darnach, um sie auch abrasionsfest zu gestalten, noch mit einer weiteren Hartstoffschicht beschichtet.
   Hierzu wurde Titankarbonitrid für Aluminiumbördelräder als Formwerkzeuge eingesetzt, Titannitrid für Spritzgussformen für Polyvinylchlorid, Chromnitridschichten für Metalldruckgussformen.
   Dabei wurden vorerst bekannte Ionenplattierverfahren eingesetzt.
   Erst bei Einsatz des erfindungsgemässen Vorgehens, Anlegen einer Gleichspannung und Entladen mit vorgegebener Häufigkeit, wurden aber einerseits die sich aufgrund der elektrisch isolierenden Unterschicht ergebenden Probleme gelöst, anderseits und insbesondere auch erst eine ausreichende Haftung der abrasionsfesten Schicht auf der Siliciumnitridschicht erzielt. Nur unter Einsatz des erfindungsgemässen Vorgehens beim Ionenplattieren konnten einsatztaugliche Werkzeuge hergestellt werden.
2. Es wurde versucht, auf bekannte Art und Weise
   Wendeschneidplatten mit physikalischen Beschichtungsverfahren zu beschichten. Dazu wurde aus einem Tiegel gleichzeitig Aluminium und Chrom verdampft. Dabei zeigte sich, dass die Schichten zwar eine ausreichende Härte aufweisen, dass jedoch in einigen Anwendungen mit besonders hoher Abrasionsbeanspruchung der Verschleisswiderstand ungenügend war.
   Eine Analyse der Schicht im Rasterelektronenmikroskop zeigte, dass die Schichten nicht ausreichend kompakt waren.
   Daraufhin wurde die gleiche Beschichtung erfindungsgemäss nach dem beschriebenen Ionenplattierverfahren vorgenommen, wodurch, wie erwünscht, eine Erhöhung des Verschleisswiderstandes an den Wendeschneidplatten resultierte.

Für die Serienfertigung gemäss beiden Beispielen mit mehr als zwei Substratträgern wurde wie in Fig. 18 dargestellt vorgegangen. Es zeigte sich, dass ein Mindestzeitraum von 10nsec zwischen Entladezyklen an den einzelnen Werkstückträgern notwendig ist. Besonders stabil ergab sich der Betrieb mit Intervallen > 200nsec zwischen den Entladezyklen einzelner Werkstückträger.

Mit diesem Verfahren konnten Werkstücke an einer grossen Zahl von Substratträgern, wie erprobt zwölf, erfindungsgemäss ionenplattiert werden, wobei bei der Beschichtung der Wendeschneidplatten deren Abrasionsverschleisswiderstand demjenigen von Wendeschneidplatten mit Schichten entsprach, die gemäss Stand der Technik mit Hochtemperatur-CVD-Methoden abgeschieden wurden.

Generell weisen Werkstücke, welche erfindungsgemäss ionenplattiert wurden, eine höhere Zähigkeit auf als Werkstücke, die mit Hochtemperatur-CVD-Methoden beschichtet werden, dies aufgrund der erfindungsgemäss tiefen Behandlungstemperaturen. Es erlaubt die hohe Zähigkeit der wie oben dargestellt erfindungsgemäss beschichteten Wendeschneidplatten einen Einsatz im ununterbrochenen Schnittbetrieb.

Es ergeben sich die weiteren wesentlichen Vorteile der Erfindung:
1. Beim Kathodenzerstäuben:
   Nebst den bereits in der Beschreibung aufgeführten Vorteilen, dass
   - der Wirkungsgrad im Sinne von aufgebrachten Schichtvolumen pro aufgewendeter elektrischer Energie gegenüber vorbekannten Verfahren erhöht wird,
   - der Uebergang vom metallischen Mode in den reaktiven bzw. oxidischen Mode flacher ist, womit ein Prozessarbeitspunkt im Uebergangsmode regelungstechnisch einfacher zu stabilisieren ist.
2. Beim erfindungsgemässen Ionenplattieren:
   Nebst den in der vorangegangenen Beschreibung aufgeführten Vorteilen, dass
   - die Hafteigenschaften erfindungsgemäss ionenplattierter Schichten verbessert werden,
   - die Kompaktheit erfindungsgemäss hergestellter ionenplattierter Schichten erhöht wird und damit ihr Verschleisswiderstand,
   - dass die Behandlungstemperatur der zu beschichtenden Substrate tief gehalten werden kann, wie beim Ionenplattieren üblich, aber dass dadurch, dass das Ionenplattieren durch seine erfindungsgemässe Durchführung dort eingesetzt werden kann, wo bis anhin üblicherweise Hochtemperatur-CVD-Methoden eingesetzt wurden, die Zähigkeit der erfindungsgemäss behandelten Substrate, gegenüber mit Hochtemperatur-CVD gleich beschichteter, wesentlich erhöht werden kann.

## Patentansprüche

1. Verfahren zur Werkstückbehandlung in einer Vakuumatmosphäre, bei welchem Verfahren zwischen mindestens zwei leitenden Flächen (2a, 2b), die mit der Vakuumatmosphäre in Wirkverbindung stehen, dabei mindestens die eine über mindestens eine Teilbelegung (4) - im weiteren "Isolationsbelegung" genannt - mit nicht oder schlecht leitendem Material, ein elektrisches Signal angelegt wird und in der Atmosphäre Ladungsträger (q) vorhanden sind, bei dem an die Flächen (2a, 2b) während der Behandlung das Ausgangssignal eines Gleichstrom-Signalgenerators (8) sowie ein weiteres elektrisches Signal (12, 14s) angelegt wird, dadurch gekennzeichnet, dass das weitere Signal (12, 14s) gezielt so oft und/oder so lange, wie es Ladungsbelegungsverhältnisse an der Isolationsbelegung erfordern, angelegt wird und dabei, über die Behandlungszeit gemittelt, das weitere Signal (12, 14s) wesentlich weniger lang angelegt wird als dasjenige des Gleichstrom-Signalgenerators (8).

2. Verfahren zur Werkstückbehandlung in einer Vakuumatmosphäre, bei welchem Verfahren in der Vakuumatmosphäre Ladungsträger (q) vorhanden sind und mindestens zwei leitende Flächen (2a, 2b), wovon mindestens eine mindestens über eine Teilbelegung (4) - im weiteren "Isolationsbelegung" genannt -, mit schlecht oder nicht leitendem Material, mit der Vakuumatmosphäre in Verbindung stehen, dadurch gekennzeichnet, dass die Flächen (2a, 2b) wiederholt zu vorgegebenen oder vorgebbaren Zeiten niederohmiger (14s) oder über eine Ladungsquelle (20) verbunden werden.

3. Verfahren nach Anspruch 1, dadurch gekennzeichnet, dass das Anlegen des weiteren Signals durch Verbinden der mindestens zwei leitenden Flächen nach Anspruch 2 erfolgt, wobei vorzugsweise während des Verbindens der Gleichstrom-Signalgenerator abgetrennt wird.

4. Verfahren nach einem der Ansprüche 1 oder 3, dadurch gekennzeichnet, dass das weitere Signal durch Zerhacken des Ausgangssignals des Generators erzeugt wird.

5. Verfahren nach Anspruch 4, dadurch gekennzeichnet, dass das weitere Signal durch Zerhacken des Spannungsausgangssignals des Generators erfolgt.

6. Verfahren nach einem der Ansprüche 1 bis 5, dadurch gekennzeichnet, dass die Werkstückbehandlung eine Ionenplattierbehandlung ist.

7. Verfahren nach einem der Ansprüche 1 bis 6, dadurch gekennzeichnet, dass in der Vakuumatmosphäre ein Plasma erzeugt wird.

8. Verfahren nach Anspruch 7, dadurch gekennzeichnet, dass das Plasma ab einer der erwähnten Flächen gespiesen wird.

9. Verfahren nach einem der Ansprüche 2 bis 8, dadurch gekennzeichnet, dass das Entlade- bzw. Umladeverhalten in einem die Flächen mitumfassenden Stromkreis gemessen wird.

10. Verfahren nach Anspruch 9, dadurch gekennzeichnet, dass das gemessene Entlade- bzw. Umladeverhalten mit einem SOLL-Verhalten verglichen wird und, in Funktion des Vergleichsresultates, die Ladungsbelegung durch externe Ladungseinspeisung und/oder Aenderung der Entlade- bzw. Umladezyklushäufigkeit und/oder Aenderung der Entlade- bzw. Umladezykluslänge so gestellt wird, dass das resultierende, gemessene Entlade- bzw. Umladeverhalten dem SOLL-Verhalten mindestens angenähert wird.

11. Verfahren nach einem der Ansprüche 9 oder 10, dadurch gekennzeichnet, dass durch die Ladungsbelegung bewirkte spontane Entladeerscheinungen beobachtet werden und, je nach Erscheinungshäufigkeit und/oder Erscheinungsart, diese Belegung durch externe Ladungseinspeisung und/oder Aenderung der Entlade- bzw. Umladezyklushäufigkeit und/oder Aenderung der Entlade- bzw. Umladezykluslãnge so gesteuert oder geregelt wird, dass ein erwünschtes Verhalten bezüglich der genannten Spontanentladungen erreicht wird.

12. Verfahren nach einem der Ansprüche 9 bis 11, dadurch gekennzeichnet, dass, wenn der gemessene Entlade- oder Umladevorgang einen vorgegebenen Zustand erreicht, dieser Vorgang abgebrochen wird.

13. Verfahren nach einem der Ansprüche 2 bis 12, dadurch gekennzeichnet, dass in Phasen zwischen Entlade- bzw. Umladezyklen ein Ladungsbelegungsaufbau durch externes Einspeisen einer Ladung auf die zu belegende der Flächen bzw. der isolationsbelegten Fläche gesteuert wird.

14. Verfahren nach Anspruch 13, dadurch gekennzeichnet, dass der Ladungsbelegungsaufbau als Schichtaufbau auf mindestens ein Werkstück beim Ionenplattieren gesteuert wird.

15. Verfahren nach einem der Ansprüche 1 bis 14, dadurch gekennzeichnet, dass die Werkstückoberfläche, selbst als Isolationsbelegung wirkend, schlecht oder nicht leitend ist und durch Ionenplattieren beschichtet wird und/oder die Werkstückoberfläche mit einer Schicht aus schlecht oder nicht leitendem Material als Isolationsbelegung durch Ionenplattieren beschichtet wird und dabei eine Werkstückträgerfläche eine leitende der genannten Flächen ist und dass der Trägerfläche ein kapazitives Element im Entladekreis seriegeschaltet wird, derart, dass in Plattierungsphasen diese Kapazität und der durch die mindestens eine Isolationsbelegung am Werkstück gebildete Kondensator in Serie erscheinen, in Entladezyklen parallel, und dass in Plattierungsphasen der Seriekreis so aufgeladen wird, dass eine im wesentlichen vorgebbare Ionenbelegung an den Werkstücken erfolgt.

16. Verfahren nach Anspruch 15, dadurch gekennzeichnet, dass in Plattierungsphasen eine vorgegebene oder vorgebbare Ladung durch die Serieschaltung von Kapazität und Kondensator getrieben wird und damit die Belegung mit Ladungsträgern an der Werkstückoberfläche gesteuert wird.

17. Verfahren nach Anspruch 16, dadurch gekennzeichnet, dass die Ladung durch Aufschalten einer Spannung mit vorgegebenem oder vorgebbarem Verlauf ihrer Aenderung in der Zeit durch die Serieschaltung getrieben wird.

18. Verfahren nach einem der Ansprüche 15 bis 17, dadurch gekennzeichnet, dass die Aufladung des Seriekreises mittels einer induktiven Spannungsüberhöhung im Seriekreis erfolgt.

19. Verfahren nach einem der Ansprüche 15 bis 18, dadurch gekennzeichnet, dass die Aufladung des Seriekreises in den Plattierungsphasen mit einer Rampenspannung im wesentlichen mit einem konstanten Strom erfolgt und damit eine im wesentlichen konstante Ladungsbelegungsrate erzeugt wird.

20. Verfahren nach einem der Ansprüche 15 bis 19, dadurch gekennzeichnet, dass der Entladevorgang mit einer Repetitionsfrequenz von 50kHz bis 500kHz vorgenommen wird, bevorzugterweise mit mindestens 90kHz, bevorzugterweise mit mindestens 100kHz.

21. Verfahren nach einem der Ansprüche 1 bis 20, dadurch gekennzeichnet, dass zwei oder mehr Paare der Flächen vorgesehen sind, je Paare oder je Paargruppen mit einem Gleichstromgenerator und/oder mit einem Entlade- bzw. Umladestromzweig zeitgestaffelt betrieben werden.

22. Verfahren nach einem der Ansprüche 1 bis 21, dadurch gekennzeichnet, dass Werkstücke auf mindestens zwei vorgesehenen Paaren oder Gruppen der Flächen durch Ionenplattieren behandelt werden und die Paare oder Gruppen zeitgestaffelt Entladezyklen unterworfen werden.

23. Verfahren nach einem der Ansprüche 1 bis 13, dadurch gekennzeichnet, dass in der Vakuumatmosphäre ein leitendes Material mittels einer Plasmaentladung zerstäubt wird, welche zwischen dem zu zerstäubenden Material und einer Gegenelektrode unterhalten wird, dass das zerstäubte Material mit in die Vakuumatmosphäre eingelassenem Reaktivgas zur Bildung einer nicht oder schlecht leitenden Materialverbindung im Plasma zur Reaktion gebracht wird, und über der Plasmaentladungsstrecke ein gesteuerter Entladestromkreis sowie dazu in Serie der Gleichstrom-Signalgenerator und eine Unterbrechungsschaltstrecke, wobei letztere und das Durchschalten des Entladestromkreises intermittierend angesteuert werden.

24. Verfahren nach Anspruch 23, dadurch gekennzeichnet, dass das Zerstäuben unter eingelassenem Reaktivgas im oxidischen oder im Uebergangsmode betrieben wird.

25. Verfahren nach einem der Ansprüche 23 oder 24, dadurch gekennzeichnet, dass das weitere Signal mit einer Häufigkeit entsprechend 50Hz bis 1MHz, vorzugsweise entsprechend 5kHz bis 100kHz, vorzugsweise dabei insbesondere von 10kHz bis 20kHz, angelegt wird.

26. Verfahren nach einem der Ansprüche 1, 3 bis 25, dadurch gekennzeichnet, dass das weitere Signal jeweils mit Längen von 50nsec bis 10µsec, vorzugsweise von 0,5µsec bis 2µsec oder von 2µsec bis 10µsec, angelegt wird.

27. Vakuumbehandlungsanlage mit einem Vakuumrezipienten (3), darin einer Trägeranordnung zur Werkstückaufnahme, bei welcher Anlage ein Gleichstrom-Signalgenerator (8) sowie eine weitere Signalquelle (12, 14s) an mindestens zwei leitende Flächen (2a, 2b) angelegt sind, die mit der Atmosphäre im Vakuumrezipienten in Wirkverbindung stehen, dadurch gekennzeichnet, dass die weitere Signalquelle (12, 14s), mittels einer Zeitsteuereinheit (10) getaktet, an die Flächen (2a, 2b) angelegt ist, womit das Ausgangssignal der weiteren Signalquelle (12, 14s), über eine Behandlungszeit gemittelt, wesentlich weniger lang angelegt wird als das Ausgangssignal des Gleichstrom-Signalgenerators (8).

28. Vakuumbehandlungsanlage mit einem Vakuumrezipienten (3), darin einer Trägeranordnung zur Werkstückaufnahme, weiter mit Mitteln zur Erzeugung von Ladungsträgern im Rezipienten und mit zwei leitenden Flächen (2a, 2b), die mit der Atmosphäre im Rezipienten (3) in Wirkverbindung stehen, dadurch gekennzeichnet, dass die Flächen über einen mittels einer Zeitsteuereinheit (16, 160) wiederholt angesteuerten Entlade- oder Umladestromkreis (14, 14s, S₁) miteinander verbunden sind.

29. Vakuumbehandlungsanlage nach Anspruch 27, dadurch gekennzeichnet, dass die weitere Signalquelle durch einen Entlade- oder Umladestromzweig nach Anspruch 28 gebildet ist.

30. Vakuumbehandlungsanlage nach einem der Ansprüche 28 oder 29, dadurch gekennzeichnet, dass die zwei leitenden Flächen (2a, 2b) über eine gesteuerte Kurzschluss-Schalteinheit (14s, S₁) verbunden sind.

31. Vakuumbehandlungsanlage nach Anspruch 30, dadurch gekennzeichnet, dass die Kurzschluss-Schalteinheit (S₁) dem Gleichstrom-Signalgenerator (8) und den zwei leitenden Flächen zwischengeschaltet ist.

32. Vakuumbehandlungsanlage nach einem der Ansprüche 27 bis 31, dadurch gekennzeichnet, dass eine der leitenden Flächen (29) eine Fläche zur Werkstückaufnahme oder eine Fläche (52, 2b) zur Aufnahme eines Quellenmaterials ist, welches Quellenmaterial bei der Beschichtung mindestens eines Werkstückes (1) eingesetzt wird.

33. Vakuumbehandlungsanlage nach einem der Ansprüche 27 bis 32, dadurch gekennzeichnet, dass eine der leitenden Flächen (2a) eine Werkstückaufnahmefläche ist und die Anlage eine Ionenplattieranlage.

34. Vakuumbehandlungsanlage nach einem der Ansprüche 27 bis 33, dadurch gekennzeichnet, dass ein Zielobjekt (64) vorgesehen ist, welches zerstäubt wird, und eine der leitenden Flächen (2b) über das Zielobjekt (64) mit der Vakuumatmosphäre in Wirkverbindung steht.

35. Anlage nach einem der Ansprüche 27 bis 34, dadurch gekennzeichnet, dass Mittel (52, 50; 3, 64) zur Erzeugung einer Plasmaentladung (PL) vorgesehen sind.

36. Anlage nach einem der Ansprüche 27 bis 35, dadurch gekennzeichnet, dass mindestens drei (2a₁, 2a₂, 2b) der erwähnten leitenden Flächen vorgesehen sind und ihnen paarweise je ein Generator (8) nach Anspruch 27 und/oder ein Stromzweig nach Anspruch 28 zugeordnet ist, die über eine Zeitsteuereinheit (70), in der Zeit gestaffelt, angesteuert sind.

37. Anlage nach einem der Ansprüche 27 bis 36, dadurch gekennzeichnet, dass in den Vakuumrezipienten eine Gaszuführung (18) ausmündet, die mit einem Vorrat an Reaktivgas verbunden ist.

38. Anlage nach einem der Ansprüche 27 bis 37, dadurch gekennzeichnet, dass mindestens zwei Elektroden (60a, 60b) zur Erzeugung eines Plasmas (PL) im Vakuumrezipienten (3) vorgesehen sind und dass eine der Elektroden (60b) auf das Potential einer der erwähnten leitenden Flächen (62) gelegt ist.

39. Anlage nach einem der Ansprüche 27 bis 38, dadurch gekennzeichnet, dass in den Entladestromzweig ein Ladungsspeicher (C_{D}, 20, C_{D1}) und/oder eine Spannungsquelle (U_{E}) geschaltet ist.

40. Anlage nach einem der Ansprüche 27 bis 39, dadurch gekennzeichnet, dass eine Messeinrichtung (24; 32; 66) am Entlade- oder Umladestromkreis vorgesehen ist zur Messung eines für den Strom im genannten Zweig repräsentativen Signals.

41. Anlage nach Anspruch 40, dadurch gekennzeichnet, dass das Ausgangssignal der Messeinrichtung auf ein Steuerglied oder eine Steuereinheit (30; 16, 160; 56; 73) für die Steuerung des Entlade- oder Umladestromkreises rückwirkt.

42. Anlage nach Anspruch 40 oder 41, dadurch gekennzeichnet, dass der Ausgang der Messeinrichtung auf eine schwellwertsensitive Einheit (26) mit vorzugsweise einstellbarem Schwellwert (W) wirkt, deren Ausgang auf einen Steuereingang (30, R) für den Entlade- oder Umladestromzweig wirkt.

43. Anlage nach einem der Ansprüche 40 bis 42, dadurch gekennzeichnet, dass der Ausgang der Messeinrichtung, gegebenenfalls über einen Analog/Digital-Wandler (34), einer IST-Wert-Speichereinrichtung (36) zugespiesen wird, deren Ausgang zusammen mit dem Ausgang einer SOLL-Wert-Speichereinrichtung (40) einer Vergleichereinheit (38) zugeführt ist, und dass der Ausgang der Vergleichereinheit (38), gegebenenfalls über eine Auswerteeinheit (42), auf einen Steuereingang für den gesteuerten Entlade- oder Umladestromzweig einwirkt.

44. Anlage nach einem der Ansprüche 27 bis 43, dadurch gekennzeichnet, dass eine gesteuerte oder steuerbare Ladungsquelle (20, 22, 44; 58, C_{D1}) auf die Strecke zwischen den zwei leitenden Flächen (2a, 2b) wirkt, insbesondere in Zeitabschnitten, in welchen der Entlade- bzw. Umladestromzweig gesteuert unterbrochen bzw. hochohmig angesteuert ist.

45. Anlage nach einem der Ansprüche 27 bis 44, dadurch gekennzeichnet, dass mindestens einer der elektrisch leitenden Flächen (2a) ein kapazitives Element (C_{D1}) im Stromzweig vorgeschaltet ist und dass Mittel (46, 46a, 58) vorgesehen sind, um die mit dem kapazitiven Element (C_{D1}) seriegeschaltete Strecke zwischen den leitenden Flächen (2a, 2b) gesteuert aufzuladen, wobei bei durchgeschaltetem Stromzweig (S₁) das kapazitive Element mit der Strecke parallel liegt.

46. Anlage nach einem der Ansprüche 27 bis 45, dadurch gekennzeichnet, dass mindestens einer der Flächen (2a) ein kapazitives Element (C_{D1}) vorgeschaltet ist und dass, bei hochohmig angesteuertem oder unterbrochenem Stromzweig, die Strecke zwischen den zwei leitenden Flächen (2a, 2b) mit dem kapazitiven Element in Serie geschaltet ist und hierzu in Serie eine Spannungsquelle (58) liegt, welche ein in der Zeit gesteuert oder steuerbar sich änderndes Ausgangssignal (dU/dt) abgibt, derart, dass durch die Serieschaltung, in Funktion der zeitlichen Aenderung des Spannungsquellen-Ausgangssignals, ein gesteuerter oder steuerbarer Strom fliesst.

47. Anlage nach einem der Ansprüche 27 bis 46, dadurch gekennzeichnet, dass die Anlage eine Ionenplattieranlage ist und eine der leitenden Flächen (2a) Träger für Werkstücke (1) bildet, dass über ein kapazitives Element (C_{D1}) und eine gesteuerte Schaltstrecke (S₁) der Entladestromzweig über den leitenden Flächen (2a, 2b) gebildet ist, der Gleichstrom-Signalgenerator (8) parallel zur Schaltstrecke (S₁) liegt und vorzugsweise eine Ladungsquelle (58, C_{D1}) in Serie mit der erwähnten Strecke (S₁) und dem kapazitiven Element (C_{D1}) wirkt oder mit letzterem (C_{D1}) eine Ladungsquelle gebildet wird, welche Ladungsquelle mit dem Betrieb der Schaltstrecke (S₁) so synchronisiert ist, dass bei unterbrochener Schaltstrecke (S₁) ein vorgegebener oder vorgebbarer Ladestrom über die Strecke zwischen den leitenden Flächen (2a, 2b) fliesst.

48. Anlage nach Anspruch 47, dadurch gekennzeichnet, dass mehrere der als Werkstückträger wirkenden Flächen (2aₓ) vorgesehen sind, ihnen je eine Schaltstrecke (S₁) zur Bildung des Entladestromzweiges zugeordnet ist, ebenso wie je ein kapazitives Element (C_{D1}), und vorzugsweise je eine Ladungsquelle (58, C_{D1}) oder je mit den kapazitiven Elementen (C_{D1}) eine Ladungsquelle gebildet ist, und dass die Zeitsteuereinheit (162, 71) die Schaltstrecken (S₁) zeitgestaffelt ansteuert.

49. Anlage nach einem der Ansprüche 27 bis 48, dadurch gekennzeichnet, dass in der Anlage ein Zerstäubungszielobjekt (64) vorgesehen ist, woran eine der leitenden Flächen (2b) vorgesehen ist, und dass die zwei Flächen (2a, 2b) über eine gesteuerte Schaltstrecke (S₁) zur Bildung des Entladestromzweiges verbunden sind, im weiteren, über eine Serieschaltstrecke (S₂), der Gleichstrom-Signalgenerator (8) vorgesehen ist, dabei die Schaltstrecken (S₁, S₂) durch die Zeitsteuereinheit (160) intermittierend betrieben sind.

50. Anlage nach Anspruch 49, dadurch gekennzeichnet, dass Detektionsmittel für Störentladungen (66) im Rezipienten (3) vorgesehen sind, deren Ausgangssignal auf eine Vergleichseinheit (70) geführt ist, welcher das Ausgangssignal einer SOLL-Wert-Vorgabeeinheit (72) zugeführt ist, und dass das Ausgangssignal der Vergleichseinheit (70) auf eine Steuereinheit, vorzugsweise auf die Zeitsteuereinheit (16, 160) einwirkt, welche den intermittierenden Betrieb der Schaltstrecken (S₁) ansteuert.

## Claims

1. Process for workpiece treatment in a vacuum atmosphere, in which process an electric signal is applied between at least two conductive surfaces (2a, 2b) actively connected with the vacuum atmosphere, where at least the one of which has non- or poorly conductive material applied via at least one partial coating (4) - referred to below as "insulation coating" - and in the atmosphere charge carriers (q) are present where during the treatment, the output signal from a direct current signal generator (8) and a further electrical signal (12, 14s) are applied at the surfaces (2a, 2b), characterized in that the further signal (12, 14s) is applied in a targeted manner as often and/or for as long as required by the charge coating conditions at the insulation coating, and where,taken the average over the treatment time, the further signal (12, 14s) is applied for an essentially shorter time than the signal from the direct current generator.

2. Process for workpiece treatment in a vacuum atmosphere, in which process charge carriers (q) are present in the vacuum atmosphere and at least two conductive surfaces (2a, 2b), at least one of which has poor or non-conductive material applied at least via one partial coating (4) - referred to below as "insulation coating" -, are connected with the vacuum atmosphere, characterized in that the surfaces (2a, 2b) are connected repeatedly at prespecified or prespecifiable times at low ohms (14s) or via a charge source (20).

3. Process according to claim 1, characterized in that the further signal is applied by connecting the at least two conductive surfaces according to claim 2, where preferably during the connection the direct current signal generator is disconnected.

4. Process according to any of claims 1 or 3, characterized in that the further signal is generated by chopping the output signal from the generator.

5. Process according to claim 4, characterized in that the further signal is generated by chopping the voltage output signal from the generator.

6. Process according to any of claims 1 to 5, characterized in that the workpiece treatment is an ion plating treatment.

7. Process according to any of claims 1 to 6, characterized in that a plasma is generated in the vacuum atmosphere.

8. Process according to claim 7, characterized in that the plasma is supplied from one of the said surfaces.

9. Process according to any of claims 2 to 8, characterized in that the discharge or recharge behaviour is measured in a circuit containing the surfaces.

10. Process according to claim 9, characterized in that the measured discharge or recharge behaviour is compared with a NOMINAL behaviour and, as a function of the comparison result, the charge coating is set by an external charge supply and/or a change to the discharge or recharge cycle frequency and/or a change to the discharge or recharge cycle length such that the resulting measured discharge or recharge behaviour at least approximates to the NOMINAL behaviour.

11. Process according to any of claims 9 or 10, characterized in that spontaneous discharge phenomena triggered by the charge coating are observed and, depending on the phenomenon frequency and/or type, this coating is controlled or regulated by an external charge supply and/or a change to the discharge or recharge cycle frequency and/or a change to the discharge or recharge cycle length such that a desired behaviour is achieved in relation to the said spontaneous discharges.

12. Process according to any of claims 9 to 11, characterized in that when the measured discharge or recharge process reaches a prespecified condition, this process is interrupted.

13. Process according to any of claims 2 to 12, characterized in that in phases between discharge or recharge cycles, a charge coating build-up is controlled by an external supply of a charge to the surface to be coated or the insulation-coated surface.

14. Process according to claim 13, characterized in that the charge coating build-up is controlled as a layer build-up on at least one workpiece during ion plating.

15. Process according to any or claims 1 to 14, characterized in that the workpiece surface, itself acting as an insulation coating, is poorly or non-conductive and is coated by ion plating and/or the workpiece surface is coated with a layer of poorly or non-conductive material as an insulation coating by ion plating and where a workpiece carrier surface is a said conductive surface and that a capacitative element is connected in series to the carrier surface in the discharge circuit such that during the plating phase, this capacitor and the condenser formed by the at least one insulation coating on the workpiece appear in series, and in parallel in the discharge cycle, and that in the plating phase the serial circuit is charged such that an essentially prespecifiable ion coating takes place on the workpiece.

16. Process according to claim 15, characterized in that in the plating phase, a prespecified or prespecifiable charge is sent through the series circuit from the capacitor and condenser and thus the coating with charge carriers on the workpiece surface is controlled.

17. Process according to claim 16, characterized in that the charge is sent through the series circuit by connection of a voltage with a prespecified or prespecifiable development of its change over time.

18. Process according to any of claims 15 to 17, characterized in that the charging of the serial circuit takes place by means of an inductive voltage increase in the serial circuit.

19. Process according to any of claims 15 to 18, characterized in that the charging of the serial circuit in the plating phase takes place with a ramp voltage essentially with a constant current and thus an essentially constant charge coating rate is generated.

20. Process according to any of claims 15 to 19, characterized in that the discharge process is carried out at a repetition frequency of 50 kHz to 500 kHz, preferably at least 90 kHz, preferably at least 100 kHz.

21. Process according to any of claims 1 to 20, characterized in that two or more pairs of surfaces are provided, each pair or pair group is operated at staggered times with a direct current generator and/or with a discharge or recharge current branch.

22. Process according to any of claims 1 to 21, characterized in that workpieces are processed by ion plating on at least two provided pairs or groups of surfaces and the pairs or groups are subjected to discharge cycles at staggered times.

23. Process according to any of claims 1 to 13, characterized in that in the vacuum atmosphere, a conductive material is sputtered by means of a plasma discharge maintained between the material to be sputtered and a counter-electrode, that the sputtered material is brought to reaction with a reactive gas introduced into the vacuum atmosphere in order to form a non- or poorly conductive material compound in the plasma, and via a plasma discharge path is created a controlled discharge circuit and in series with this are the direct current signal generator and an interrupt switch path, where the latter and the switching of the discharge current circuit are activated intermittently.

24. Process according to claim 23, characterized in that the sputtering under the introduced reactive gas is carried out in the oxidic or the transitional mode.

25. Process according to any of claims 23 or 24, characterized in that the further signal is applied with a frequency corresponding to 50 Hz to 1 MHz, preferably 5 kHz to 100 kHz, preferably in particular from 10 kHz to 20 kHz.

26. Process according to any of claims 1, 3 to 25, characterized in that the further signal is applied for lengths from 50 nsec to 10 µsec, preferably from 0.5 µsec to 2 µsec or from 2 µsec to 10 µsec.

27. Vacuum processing device with a vacuum container (3), in this a carrier arrangement to hold the workpiece, in which device a direct current signal generator (8) and a further signal source (12, 14s) are applied to at least two conductive surfaces (2a, 2b) which are actively connected with the atmosphere in the vacuum container, characterized in that the further signal source (12, 14s), cycled by means of a time control unit (10), is applied to the surfaces (2a, 2b), where the output signal from the further signal source (12, 14s), taken the average over a processing time, is applied for an essentially shorter time than the output signal from the direct current signal generator (8).

28. Vacuum processing device with a vacuum container (3), in this a carrier arrangement to hold the workpiece, also with means for generating charge carriers in the container and with two conductive surfaces (2a, 2b) which are actively connected with the atmosphere in the vacuum container (3), characterized in that the surfaces are connected together via a discharge or recharge circuit (14, 14s, S1) repeatedly activated by a time control unit (16, 160).

29. Vacuum processing device according to claim 27, characterized in that the further signal source is formed by a discharge or recharge current branch according to claim 28.

30. Vacuum processing device according to any of claims 28 or 29, characterized in that the two conductive surfaces (2a, 2b) are connected via a controlled short-circuit switch unit (14s, S₁).

31. Vacuum processing device according to claim 30, characterized in that the short-circuit switch unit (S₁) is connected between the direct current signal generator (8) and the two conductive surfaces.

32. Vacuum processing device according to any of claims 27 to 31, characterized in that one of the two conductive surfaces (29) is a surface for holding the workpiece or a surface (52, 2b) for holding a source material, where the said source material is used in coating at least one workpiece (1).

33. Vacuum processing device according to any of claims 27 to 32, characterized in that one of the conductive surfaces (2a) is a workpiece holder surface and the device is an ion plating device.

34. Vacuum processing device according to any of claims 27 to 33, characterized in that a target object (64) is provided which is sputtered, and one of the conductive surfaces (2b) is actively connected with the vacuum atmosphere via the target object (64).

35. Vacuum processing device according to any of claims 27 to 34, characterized in that means (52, 50; 3, 64) are provided to generate a plasma discharge (PL).

36. Vacuum processing device according to any of claims 27 to 35, characterized in that at least three (2a₁, 2a₂ 2b) of the said conductive surfaces are provided and to each pair of these is allocated a generator (8) according to claim 27 and/or a current branch according to claim 28, which are activated at staggered times via a time control unit (70).

37. Device according to any of claims 27 to 36, characterized in that in the vacuum container opens a gas supply (18) which is connected with a reactive gas reservoir.

38. Device according to any of claims 27 to 37, characterized in that at least two electrodes (60a, 60b) are provided to generate a plasma (PL) in the vacuum container (3) and that one of the electrodes (60b) is applied to the potential of one of the said conductive surfaces (62).

39. Device according to any of claims 27 to 38, characterized in that in the discharge current branch is connected a charge storage unit (C_{D}, 20, C_{D1}) and/or a voltage source (U_{E}).

40. Device according to any of claims 27 to 39, characterized in that a measuring device (24; 32; 66) is provided on the discharge or recharge current circuit to measure a signal representative of the current in the said branch.

41. Device according to claim 40, characterized in that the output signal from the measuring device acts on a control element or a control unit (30; 16, 160; 56; 73) to control the discharge or recharge current circuit.

42. Device according to claim 40 or 41, characterized in that the output from the measuring device acts on a threshold-sensitive unit (26) with preferably adjustable threshold value (W), the output of which acts on a control input (30, R) for the discharge or recharge current branch.

43. Device according to any of claims 40 to 42, characterized in that the output from the measuring device, where applicable via an analog/digital converter (34), is supplied to an ACTUAL value storage device (36), the output of which together with the output from a NOMINAL value storage device (40) is passed to a comparison unit (38), and that the output from the comparison unit (38), where applicable via an analysis unit (42), acts on a control unit for the controlled discharge or recharge current branch.

44. Device according to any of claims 27 to 43, characterized in that a controlled or controllable charge source (20, 22, 44; 58, C_{D1}) acts on the path between the two conductive surfaces (2a, 2b), in particular in time sections in which the discharge or recharge current branch is controlledly interrupted or activated high-ohm.

45. Device according to any of claims 27 to 44, characterized in that a capacitative element (C_{D1}) is connected in the current branch before at least one of the electrically conductive surfaces (2a) and that means (46, 46a, 58) are provided in order to controlledly charge the path between the two conductive surfaces (2a, 2b) which is connected in series with the capacitative element (C_{D1}), where with the current path (S₁) switched through, the capacitative element lies parallel with the path.

46. Device according to any of claims 27 to 45, characterized in that a capacitative element (C_{D1}) is connected before at least one of the surfaces (2a) and that with the current branch activated high-ohm or interrupted, the path between the two conductive surfaces (2a, 2b) is connected in series with the capacitative element and a voltage source (58) lies in series with this and emits an output signal (dU/dt) which changes in a controlled or controllable manner over time such that a controlled or controllable current flows through the series circuit as a function of the temporal change in the voltage source output signal.

47. Device according to any of claims 27 to 46, characterized in that the device is an ion plating device and one of the conductive surfaces (2a) forms a carrier for workpieces (1), that via a capacitative element (C_{D1}) and a controlled switch path (S₁) the discharge current branch is formed over the conductive surfaces (2a, 2b), the direct current signal generator (8) lies parallel to the switch path (S₁) and preferably a charge source (58, C_{D1}) acts in series with the said path (S₁) and the capacitative element (C_{D1}) or with the latter (C_{D1}) forms a charge source, where the said charge source is synchronized with the operation of the switch path (S₁) such that when the switch path (S₁) is interrupted, a prespecified or prespecifiable charge current flows via the path between the conductive surfaces (2a, 2b).

48. Device according to claim 47, characterized in that several of the surfaces (2aₓ) acting as workpiece carriers are provided, to each of which is allocated a switch path (S₁) to form a discharge current branch, and a capacitative element (C_{D1}) and preferably a discharge source (58, C_{D1}), or in each case a charge source is formed with the capacitative element (C_{D1}), and that the time control unit (162, 71) activates the switch paths (S₁) at staggered times.

49. Device according to any of claims 27 to 48, characterized in that in the device is provided a sputter target object (64) on which is provided one of the conductive surfaces (2b), and that the two surfaces (2a, 2b) are connected together via a controlled switch path (S₁) to form a discharge current branch, further that via a series switch path (S₂) is provided the direct current signal generator (8), where the switch paths (S₁, S₂) are operated intermittently via the time control unit (160).

50. Device according to claim 49, characterized in that detection means for disruptive discharges (66) are provided in the container (3), the output signal from which is passed to a comparison unit (70) to which is supplied the output signai from a NOMINAL value presetting unit (72), and that the output signal from the comparison unit (70) acts on a control unit, preferably on the time control unit (16, 160) which activates the intermittent operation of the switch paths (S₁).

## Revendications

1. Procédé pour le traitement de pièces dans une atmosphère sous vide, procédé dans lequel un signal électrique est appliqué entre au moins deux surfaces conductrices (2a, 2b) activement connectées à l'atmosphère sous vide, où au moins l'une d'entre elles possède une matière non ou peu conductrice appliquée par au moins une seule couche partielle (4) - appelée ci-dessous "couche isolante" - et dans l'atmosphère des porteurs de charges (q) sont présents où pendant le traitement, le signal de sortie d'un générateur de signaux à courant continu (8) et un signal électrique supplémentaire (12, 14s) sont appliqués sur les surfaces (2a, 2b), caractérisé en ce que le signal supplémentaire (12, 14s) est appliqué d'une manière ciblée aussi souvent et/ou aussi longtemps qu'il ne le faut par les conditions de couche de charges au niveau de la couche isolante, et où,pris la moyenne dans la durée du traitement, le signal supplémentaire (12, 14s) est appliqué pour une durée essentiellement plus courte que le signal provenant du générateur à courant continu.

2. Procédé pour le traitement de pièces dans une atmosphère sous vide, procédé dans lequel des porteurs de charges (q) sont présents dans l'atmosphère sous vide et au moins deux surfaces conductrices (2a, 2b), dont au moins une d'entre elles a une matière peu ou non conductrice appliquée par au moins une seule couche partielle (4) - appelée ci-dessous "couche isolante" -, sont connectées à l'atmosphère sous vide, caractérisé en ce que les surfaces (2a, 2b) sont connectées à plusieurs reprises à des moments préspécifiés ou préspécifiables à faibles ohms (14s) ou par une source de charges (20).

3. Procédé suivant la revendication 1, caractérisé en ce que le signal supplémentaire est appliqué en connectant au moins les deux surfaces conductrices suivant la revendication 2, où préférablement pendant la connexion, le générateur de signaux à courant continu est déconnecté.

4. Procédé suivant les revendications 1 ou 3, caractérisé en ce que le signal supplémentaire est créé en découpant le signal de sortie provenant du générateur.

5. Procédé suivant la revendication 4, caractérisé en que le signal supplémentaire est créé en découpant le signal de sortie en tension provenant du générateur.

6. Procédé suivant les revendications 1 à 5, caractérisé en ce que le traitement des pièces est un traitement de plaquage ionique.

7. Procédé suivant les revendications 1 à 6, caractérisé en ce qu'un plasma est créé dans l'atmosphère sous vide.

8. Procédé suivant la revendication 7, caracterise en ce que le plasma est fourni à partir de l'une desdites surfaces.

9. Procédé suivant les revendications 2 à 8, caractérisé en ce que le comportement de décharge ou de recharge est mesuré dans un circuit contenant les surfaces.

10. Procédé suivant la revendication 9, caractérisé en ce que le comportement de décharge ou de recharge mesuré est comparé à un comportement NOMINAL et, en fonction du résultat de la comparaison, la couche de charges est réglée par une alimentation de charges externe et/ou un changement de fréquence du cycle de décharge ou de recharge et/ou un changement de longueur du cycle de décharge ou de recharge afin que le comportement de décharge ou de recharge mesuré qui en résulte se rapproche au moins du comportement NOMINAL.

11. Procédé suivant les revendications 9 ou 10, caractérisé en ce que les phénomènes de décharge spontanée déclenchés par la couche de charges sont observés et, selon la fréquence et/ou le type de phénomène, cette couche est contrôlée ou régulée par une alimentation de charges externe et/ou un changement de fréquence du cycle de décharge ou de recharge et/ou un changement de longueur du cycle de décharge ou de recharge afin qu'un comportement souhaité soit réalisé par rapport auxdites décharges spontanées.

12. Procédé suivant les revendications 9 à 11, caractérisé en ce que quand le procédé de décharge ou recharge mesuré atteint une condition préspécifiée, ce procédé est interrompu.

13. Procédé suivant les revendications 2 à 12, caractérisé en ce qu'au cours des phases entre les cycles de décharge et de recharge, une accumulation de couche de charges est contrôlée par une alimentation externe d'une charge sur la surface devant être revêtue ou la surface revêtue d'un isolant.

14. Procédé suivant la revendication 13, caractérisé en ce que l'accumulation de couche de charges est contrôlée en tant qu'accumulation de couche sur au moins une pièce pendant le plaquage ionique.

15. Procédé suivant les revendications 1 à 14, caractérisé en ce que la surface de la pièce, elle-même agissant en tant que couche isolante, est peu ou non conductrice et est revêtue d'un plaquage ionique et/ou la surface de la pièce est revêtue d'une couche de matière peu ou non conductrice en tant que couche isolante par plaquage ionique et où la surface du porteur de la pièce est une surface dite conductrice et qu'un élément capacitif est connecté en série sur la surface du porteur dans le circuit de décharge afin que pendant la phase de plaquage, ce condensateur et le condenseur formé par au moins une couche isolante sur la pièce apparaissent en série, et en parallèle dans le cycle de décharge, et que dans la phase de plaquage, le circuit en série est chargé afin qu'un plaquage ionique essentiellement spécifiable ait lieu sur la pièce.

16. Procédé suivant la revendication 15, caractérisé en ce que dans la phase de plaquage, une charge préspécifiée ou préspécifiable est envoyée dans le circuit en série à partir du condensateur et condenseur et ainsi la couche avec porteurs de charges sur la surface de la pièce est contrôlée.

17. Procédé suivant la revendication 16, caractérisé en ce que la charge est envoyée dans le circuit en série par connexion d'une tension avec un développement préspécifié ou préspécifiable de son changement sur une période de temps.

18. Procédé suivant les revendications 15 à 17, caractérisé en ce que le chargement du circuit en série se fait au moyen d'une augmentation de tension inductive dans le circuit en série.

19. Procédé suivant les revendications 15 à 18, caractérisé en ce que le chargement du circuit en série dans la phase de plaquage se fait avec une tension en dent de scie essentiellement avec un courant constant et donc un taux de couche de charges essentiellement constant est produit.

20. Procédé suivant les revendications 15 à 19, caractérisé en ce que le procédé de décharge est effectué à une fréquence de répétition de 50 kHz à 500 kHz, de préférence au moins 90 kHz, de préférence au moins 100 kHz.

21. Procédé suivant les revendications 1 à 20, caractérisé en ce que deux paires ou plus de surfaces sont fournies, chaque paire ou groupe de paires est actionnée à des moments décalés avec un générateur à courant continu et/ou avec un branchement de courant de décharge ou de recharge.

22. Procédé suivant les revendications 1 à 21, caractérisé en ce que les pièces sont traitées par plaquage ionique sur au moins deux paires, ou groupes, fournies de surfaces et les paires, ou groupes, sont soumises à des cycles de décharge à des moments décalés.

23. Procédé suivant les revendications 1 à 13, caractérisé en ce que dans l'atmosphère sous vide, une matière conductrice est pulvérisée au moyen d'une décharge de plasma maintenue entre la matière devant être pulvérisée et une contre-électrode, cette matière pulvérisée est mise en réaction avec un gaz réactif introduit dans l'atmosphère sous vide afin de former un mélange de matière non ou peu conductrice dans le plasma, et par une voie de décharge de plasma un circuit de décharge contrôlé est créé et en série avec celui-ci sont le générateur de signaux à courant continu et une voie de commutation d'interruption, où cette dernière et la commutation du circuit du courant de décharge sont actionnées par intervalles.

24. Procédé suivant la revendication 23, caractérisé en ce que la pulvérisation sous le gaz réactif introduit est effectuée en mode d'oxydation ou en mode transitionnel.

25. Procédé suivant les revendications 23 ou 24, caractérisé en ce que le signal supplémentaire est appliqué à une fréquence correspondante allant de 50 Hz à 1 Mhz, de préférence de 5 kHz à 100 kHz, de préférence en particulier de 10 kHz à 20 kHz.

26. Procédé suivant les revendications 1, 3 à 25, caractérisé en ce que le signal supplémentaire est appliqué pendant des durées allant de 50 nsec à 10 µsec, de préférence de 0,5 µsec à 2 µsec ou de 2 µsec à 10 µsec.

27. Dispositif de traitement sous vide avec un conteneur sous vide (3), dans celui-ci un arrangement porteur pour porter la pièce, dispositif dans lequel un générateur de signaux à courant continu (8) et une source de signal supplémentaire (12, 14s) sont appliqués sur au moins deux surfaces conductrices (2a, 2b) qui sont activement connectées à l'atmosphère dans le conteneur sous vide, caractérisé en ce que la source de signal supplémentaire (12, 14s), cyclée au moyen d'un compteur de temps (10), est appliquée sur les surfaces (2a, 2b), où le signal de sortie provenant de la source de signal supplémentaire (12, 14s),pris la moyenne dans une durée de traitement, est appliqué pour une durée essentiellement plus courte que le signal de sortie provenant du générateur de signaux à courant continu (8).

28. Dispositif de traitement sous vide avec un conteneur sous vide (3), dans celui-ci un arrangement porteur pour porter la pièce, également avec un moyen pour créer des porteurs de charges dans le conteneur et avec les deux surfaces conductrices (2a, 2b) qui sont activement connectées à l'atmosphère dans le conteneur sous vide (3), caractérisé en ce que les surfaces sont connectées ensemble par un circuit de décharge ou de recharge (14, 14s, S1) actionné à plusieurs reprises par un compteur de temps (16, 160).

29. Dispositif de traitement sous vide suivant la revendication 27, caractérisé en ce que la source de signal supplémentaire est formée par un branchement de courant de décharge ou de recharge suivant la revendication 28.

30. Dispositif de traitement sous vide suivant les revendications 28 ou 29, caractérisé en ce que les deux surfaces conductrices (2a, 2b) sont connectées par un interrupteur de court-circuit contrôlé (14s, S₁).

31. Dispositif de traitement sous vide suivant la revendication 30, caractérisé en ce que l'interrupteur de court-circuit (S₁) est connecté entre le générateur de signaux à courant continu (8) et les deux surfaces conductrices.

32. Dispositif de traitement sous vide suivant les revendications 27 à 31, caractérisé en ce que l'une des deux surfaces conductrices (29) est une surface pour porter la pièce ou une surface (52, 2b) pour porter une matière de source, où ladite matière de source est utilisée pour revêtir au moins une pièce (1).

33. Dispositif de traitement sous vide suivant les revendications 27 à 32, caractérisé en ce que l'une des surfaces conductrices (2a) est une surface pour porter la pièce et le dispositif est un dispositif de plaquage ionique.

34. Dispositif de traitement sous vide suivant les revendications 27 à 33, caractérisé en ce qu'un objet ciblé (64) est fourni qui est pulvérisé , et une des surfaces conductrices (2b) est activement connectée à l'atmosphère sous vide par l'objet ciblé (64).

35. Dispositif de traitement sous vide suivant les revendications 27 à 34, caractérisé en ce que des moyens (52, 50; 3, 64) sont fournis pour créer une décharge de plasma (PL).

36. Dispositif de traitement sous vide suivant les revendications 27 à 35, caractérisé en ce qu'au moins trois desdites surfaces conductrices sont fournies et à chaque paire de celles-ci un générateur (8) y est alloué suivant la revendication 27 et/ou un branchement de courant suivant la revendication 28, qui sont actionnés à des moments décalés par un compteur de temps (70).

37. Dispositif suivant les revendications 27 à 36, caractérisé en ce que dans le conteneur sous vide, une alimentation de gaz (18) s'ouvre, alimentation qui est connectée à un réservoir de gaz réactif.

38. Dispositif suivant les revendications 27 à 37, caractérisé en ce qu'au moins deux électrodes (60a, 60b) sont fournies pour créer un plasma (PL) dans le conteneur sous vide (3) et que l'une des électrodes (60b) est appliquée au potentiel de l'une desdites surfaces conductrices (62).

39. Dispositif suivant les revendications 27 à 38, caractérisé en ce que dans le branchement de courant de décharge il est raccordé un appareil de stockage de charges (C_{D}, 20, C_{D1}) et/ou une source de tension (U_{E}).

40. Dispositif suivant les revendications 27 à 39, caractérisé en ce qu'un dispositif de mesure (24; 32; 66) est fourni sur le circuit de courant de décharge ou de recharge pour mesurer un signai representatif du courant dans iedit branchement.

41. Dispositif suivant la revendication 40, caractérisé en ce que le signal de sortie du dispositif de mesure agit sur un élément de contrôle ou un appareil de contrôle (30; 16, 160; 56; 73) pour contrôler le circuit de courant de décharge ou de recharge.

42. Dispositif suivant les revendications 40 ou 41, caractérisé en ce que la sortie du dispositif de mesure agit sur un appareil à seuil (26) avec de préférence une valeur de seuil réglable (W), dont la sortie agit sur une entrée de contrôle (30, R) pour le branchement de courant de décharge ou de recharge.

43. Dispositif suivant les revendications 40 à 42, caractérisé en ce que la sortie du dispositif de mesure, quand applicable par un convertisseur analogique-numérique (34), est fournie à un dispositif de stockage à valeur REELLE (36), dont la sortie avec la sortie du dispositif de stockage à valeur NOMINALE (40) est passée dans un comparateur (38) et la sortie du comparateur (38), quand applicable par un appareil d'analyse (42), agit sur un appareil de contrôle pour le branchement de courant de décharge ou de recharge.

44. Dispositif suivant les revendications 27 à 43, caractérisé en ce qu'une source de charge contrôlée ou contrôlable (20, 22, 44; 53, C_{D1}) agit sur la voie entre les deux surfaces conductrices (2a, 2b), en particulier en sections temporelles dans lesquelles le branchement de courant de décharge ou de recharge est interrompu ou actionné de manière contrôlée à des valeurs ohmiques élevées.

45. Dispositif suivant les revendications 27 à 44, caractérisé en ce qu'un élément capacitif (C_{D1}) est connecté dans le branchement de courant avant au moins une des surfaces électriquement conductrices (2a) et ces moyens (46, 46a, 58) sont fournis afin de charger de manière contrôlée la voie entre les deux surfaces conductrices (2a, 2b) qui est connectée en série avec l'élément capacitif (C_{D1}), où avec la voie de courant (S₁) commutée, l'élément capacitif repose parallèle à la voie.

46. Dispositif suivant les revendications 27 à 45, caractérisé en ce qu'un élément capacitif (C_{D1}) est connecté avant au moins une des surfaces (2a) et qu'avec le branchement de courant actionné à valeurs ohmiques élevées ou interrompu, la voie entre les deux surfaces conductrices (2a, 2b) est connectée en série avant l'élément capacitif et une source de tension (58) repose en série avec ceci et émet un signal de sortie (dU/dt) qui change d'une manière contrôlée ou contrôlable au cours du temps afin qu'un courant contrôlé ou contrôlable s'écoule dans le circuit en série en fonction du changement temporel dans le signal de sortie de la source de tension.

47. Dispositif suivant les revendications 27 à 46, caractérisé en ce que le dispositif est un dispositif de plaquage ionique et une des surfaces conductrices (2a) forme un porteur pour les pièces (1), que par un élément capacitif (C_{D1}) et une voie de commutation contrôlée (S₁), le branchement de courant de décharge est formé sur les surfaces conductrices (2a, 2b), le générateur de signaux à courant continu (8) repose parallèle à la voie de commutation (S₁) et de préférence une source de charge (58, C_{D1}) agit en série avec ladite voie (S₁) et l'élément capacitif (C_{D1}) ou avec ce dernier (C_{D1}) forme une source de charge, où ladite source de charge est synchronisée avec l'opération de la voie de commutation (S₁) afin que lorsque la voie de commutation (S₁) est interrompue, un courant de charge préspécifié ou préspécifiable s'écoule par la voie entre les surfaces conductrices (2a, 2b).

48. Dispositif suivant la revendication 47, caractérisé en ce que plusieurs des surfaces (2aₓ) agissant en tant que porteurs de pièce sont fournies, à chacune d'entre elle a été allouée une voie de commutation (S₁) pour former un branchement de courant de décharge et un élément capacitif (C_{D1}) et de préférence une source de décharge (58, C_{D1}), ou dans chaque cas une source de charge est formée avec l'élément capacitif (C_{D1}), et que le compteur de temps (162, 71) actionne les voies de commutation (S₁) à des moments décalés.

49. Dispositif suivant les revendications 27 à 48, caractérisé en ce que dans le dispositif un objet ciblé de pulvérisation (64) est fourni sur lequel est fournie une des surfaces conductrices (2b), et que les deux surfaces (2a, 2b) sont connectées ensemble par une voie de commutation contrôlée (S₁) pour former un branchement de courant de décharge, de plus que par une voie de commutation en série (S₂) est fourni le générateur de signaux à courant continu (8), où les voies de commutation (S₁, S₂) sont actionnées par intervalles par le compteur de temps (160).

50. Dispositif suivant la revendication 49, caractérisé en ce que des moyens de détection de décharges disruptives (66) sont fournis dans le conteneur (3), dont le signal de sortie est passé dans le comparateur (70) auquel est envoyé le signal de sortie de l'appareil de préréglage à valeur NOMINALE (72), et que le signal de sortie du comparateur (70) agit sur un appareil de contrôle, de préférence sur le compteur de temps (16, 160) qui actionne l'opération intermittente des voies de commutation (S₁).
